# FASCICULE DE BREVET EUROPEEN

(11) **EP 2 449 635 B1**
(45) Date de publication et mention de la délivrance du brevet: **29.07.2015**
(21) Numéro de dépôt: 10745343.3
(22) Date de dépôt: 28.06.2010
(51) Int. Cl.: H01R 13/66, H01M 10/48, H01R 11/28

(54) **COSSE DE BATTERIE EQUIPEE D'UN SHUNT DE MESURE DU COURANT DE LA BATTERIE**
BATTERIEKABELSCHUH MIT SHUNT ZUR MESSUNG DES BATTERIESTROMS
BATTERY TERMINAL LUG EQUIPPED WITH A SHUNT FOR MEASURING THE BATTERY CURRENT

(30) Priorité: 02.07.2009 FR 0954526
(43) Date de publication de la demande: 09.05.2012
(73) Titulaire: Valeo Equipements Electriques Moteur, 94046 Créteil Cedex (FR)
(72) Inventeur: THIMON, Alain, F-93230 Romainville (FR); GRAVAT, Denis, F-62630 Etaples (FR); PERARD, Sébastien, F-62520 Le Touquet (FR); BOGAERT, Nicolas, F-62630 Etaples (FR); RYCKEBUSCH, Emmanuel, F-62630 Etaples (FR); MONTEIL, Christophe, F-75011 Paris (FR); GERVAIS, Hugues, F-77186 Noisiel (FR)
(74) Mandataire: Tran, Chi-Hai
(86) Numéro de dépôt international: PCT/FR2010/051326
(87) Numéro de publication internationale: WO 2011/001085

(56) Documents cités:
- WO-A1-2008/151181
- DE-A1-102004 055 847
- DE-A1-102007 018 669
- DE-U1-202008 017 318
- FR-A1- 2 910 719

## Description

### Domaine de l'invention

La présente invention se rapporte à une cosse de batterie équipée d'un shunt de mesure du courant de la batterie.

### Etat de la technique

Une telle cosse est décrite par exemple dans le document FR 2 866 158 auquel on se reportera pour plus de précisions.

Dans ce document la cosse de batterie, électriquement conductrice et configurée pour être montée sur une borne de la batterie, présente une branche dans laquelle est réalisé un perçage dans lequel est monté un manchon électriquement isolant pour le passage d'une tige de connexion reliée à un câble de batterie par exemple relié à la masse du véhicule automobile.

L'extrémité libre de la tige porte un premier tenon.

La cosse présente un deuxième tenon. Un shunt de mesure du courant de la batterie présente à chacune de ses extrémités respectivement un premier perçage et un deuxième perçage pour le montage à force respectivement du premier tenon et du deuxième tenon. Le shunt est relié à un support portant des composants électroniques représentés schématiquement pour prise en compte du résultat de la mesure avec éventuellement analyse de celui-ci.

Les composants électroniques, outre le courant de la batterie, peuvent capter d'autres paramètres de la batterie, tels que la température et la tension de la batterie. Ces paramètres peuvent être analysés en permanence et utilisés pour suivre l'état de charge et l'état de santé de la batterie.

En pratique le support est porté mécaniquement à surélévation par le shunt par l'intermédiaire de moyens de liaison électrique.

Il peut être souhaitable de protéger le support et le shunt.

On peut songer alors à faire appel à une solution décrite dans le document DE 10 2004 055 847, dans lequel la cosse de la batterie, destinée à être fixée sur une borne de la batterie, est en une seule partie et comporte un prolongement de support d'un shunt monté dans l'espace creux délimité par le shunt et le prolongement de la cosse. Le shunt comporte, d'une part, deux parties électriquement conductrices de raccordement respectivement au prolongement de la cosse et au câble concerné de la batterie et d'autre part, une partie intermédiaire de mesure. Le prolongement de la cosse est relié électriquement à la partie de raccordement concernée du shunt par exemple par soudage ou brasage. L'autre partie de raccordement du shunt, est reliée à isolation électrique au prolongement de la cosse par vissage.

Dans le document FR 2 910 719 le shunt est également fixé par l'une de ses parties de raccordement à contact électrique sur le prolongement de la cosse en une partie et est en contact électrique via son autre partie de raccordement avec le câble concerné de la batterie. Des moyens d'isolation électrique interviennent au niveau du câble entre le shunt et le prolongement de la cosse.

Ces moyens d'isolation électrique appartiennent dans un mode de réalisation à un carter de logement d'un circuit électrique qui utilise les informations du shunt. Les fixations du shunt respectivement à la partie de raccordement et au câble sont réalisées par des vis et des écrous.

Dans ces deux documents le shunt est de grande longueur.

### Objet de l'invention

La présente invention a pour objet de répondre au souhait de protéger le support et le shunt tout en ayant un shunt de longueur réduite.

Suivant l'invention une cosse du type sus indiquée comportant une première partie configurée pour être fixée sur une borne de la batterie est caractérisée en ce qu'elle comporte une deuxième partie configurée pour être reliée au câble de la batterie associé à la borne de la batterie, en ce que les deux parties sont distinctes l'une de l'autre et dotées de portions saillantes configurées pour porter le shunt et un carter de logement du shunt et du support et en ce que des moyens d'isolation électrique interviennent entre les deux parties de la cosse.

Grâce à l'invention le shunt et le support sont protégés puisqu'ils sont logés dans un carter. En outre le shunt présente une longueur plus faible et est moins sollicité mécaniquement puisque la deuxième partie de la cosse est destinée à être relié au câble concerné de la batterie, tandis que la première partie de la cosse est destinée à être reliée à la borne de la batterie.

Suivant d'autres caractéristiques prises isolément ou en combinaison
- le carter de forme creuse comporte un boîtier fermé par un couvercle ;
- dans un mode de réalisation le boîtier est plus profond que le couvercle ;
- dans un autre mode de réalisation le couvercle est plus profond que le boîtier ;
- le boîtier ou le couvercle comporte des moyens pour positionner mécaniquement le support ;
- les moyens pour positionner le support comportent des colonnettes épaulées appartenant au boîtier et traversant chacune une ouverture du support ;
- le corps du boîtier ou le corps du couvercle appartiennent aux moyens pour positionner le support par coopération de formes ;
- le boîtier ou le couvercle comporte des moyens d'appui mécanique pour le support ;
- les moyens d'appui mécanique sont constitués par des saillies verticales issues du fond du boîtier ou du couvercle pour contact avec la face inférieure du support ;
- le carter est configuré pour immobiliser le support;
- le couvercle du carter est configuré pour venir en appui sur la face supérieure du support ;
- les portions saillantes des deux parties de la cosse sont implantées globalement l'une au dessus de l'autre ;
- le carter présente une ouverture latérale dans laquelle pénètre les portions saillantes deux parties de la cosse ;
- le carter est rempli de résine de fixation du boîtier aux portions saillantes des deux parties de la cosse et de protection des composants montés dans le carter;
- les portions saillantes consistent en des bras de support du shunt.

D'autres avantages apparaîtront à la lumière de la description qui va suivre à titre non limitatif et en regards des dessins annexés.

### Brève description des dessins

- les figures 1 à 4 sont des vues en perspective, sous différents angles, de la cosse selon l'invention comportant une première partie destinée à être fixée sur une borne de la batterie du véhicule et une deuxième partie destinée à être fixée sur le câble de batterie associé à cette borne de la batterie ;
- la figure 5 est une vue de dessous de la première partie de la cosse des figures 1 à 4 ;
- les figures 6 et 7 sont des vues en perspective sous différents angles de la première partie de la cosse des figures 1 à 4 ;
- les figures 8 et 9 sont des vues en perspective sous différents angles de la deuxième partie de la cosse des figures 1 à 4 ;
- les figures 10 à 13 sont des vues en perspective sous différents angles de l'entretoise électriquement isolante intercalée entre les deux parties électriquement conductrices de la cosse des figures 1 à 4 ;
- la figure 14 est une vue du goujon appartenant aux moyens de fixation du câble concernée de la batterie sur la cosse des figures 1 à 4 ;
- la figure 15 est une vue en perspective de l'ensemble isolé boîtier- couvercle appartenant à la cosse des figures 1 à 4 ;
- la figure 16 est une vue de dessus du boîtier de la figure 15 ;
- la figure 17 est une vue de dessous du couvercle de la figure 15 ;
- la figure 18 est une vue analogue à la figure 16 montrant le boîtier équipé du shunt de mesure de courant, que comporte la cosse des figures 1 à 4, les autres pièces étant enlevées ;
- la figure 19 est une vue analogue à la figure 18 montrant le boîtier équipé de son support ;
- la figure 20 est une vue analogue à la figure 15 dans laquelle le boîtier est représenté seul et est équipé du shunt et du support des figures 18 et 19 ;
- la figure 21 est une vue en perspective de la deuxième partie de la cosse équipée du shunt appartenant à la cosse ;
- la figure 22 est une vue en perspective des deux parties de la cosse équipées du shunt de la figure 21 ;
- la figure 23 est une vue analogue à la figure 22 sous un autre angle avec mise en place du boîtier ;
- la figure 24 est une vue partielle selon la flèche 24 de la figure 23 ;
- la figure 25 est une de la cosse sans son couvercle et sans son support ;
- la figure 26 est une vue en perspective du boîtier de la cosse pour un autre exemple de réalisation ;
- la figure 27 est une vue en perspective de dessous du support de la cosse pour un autre exemple de réalisation ;
- la figure 28 est une vue en coupe de la cosse équipée du boîtier et du support des figures 26 et 27 :
- la figure 29 est une vue partielle de dessus du boîtier équipé du support de la figure 27 ;
- la figure 30 est une vue partielle en coupe montrant un autre type de montage du support dans le boîtier de la cosse, ainsi qu'un autre type de liaison entre le shunt et le support ;
- la figure 31 est une vue partielle analogue à la figure 28 pour encore un autre exemple de réalisation de l'invention.

### Description d'exemples de réalisation

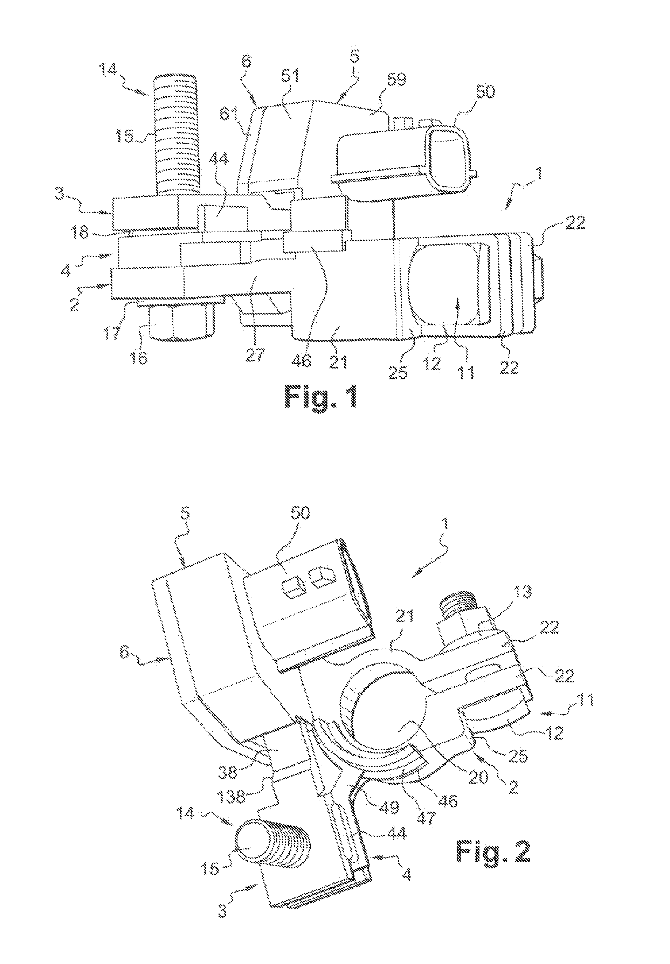

Dans les figures 1 à 4 on voit en 1 la cosse de batterie selon l'invention.

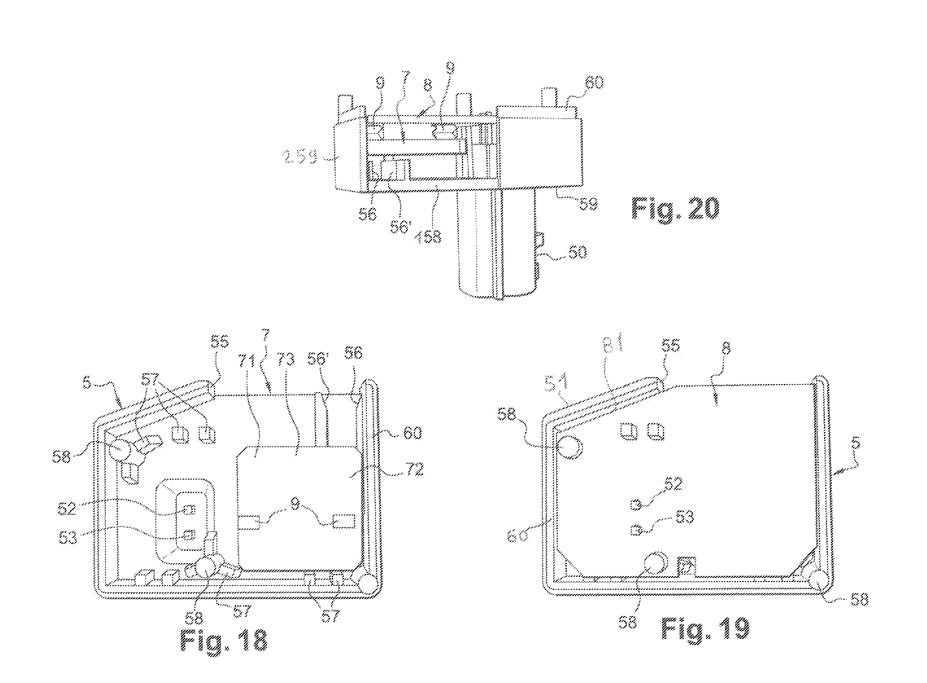

Cette cosse 1 est équipée d'un shunt de mesure du courant de la batterie référencé en 7 dans les figures 18, 20 à 22 et 25.

Cette cosse, électriquement conductrice, est modifiée par rapport à celle du document FR 2 866 158, pour notamment diminuer la longueur du shunt.

Ainsi suivant une caractéristique la cosse 1 est en deux parties 2, 3 distinctes l'une de l'autre et dotées de portions saillantes respectivement 28, 38 configurées pour porter le shunt 7 et un carter 5, 6 de logement du shunt 7 et d'un support 8 associé au shunt 7 de manière décrite ci-après.

Une première 2 de ces parties est configurée pour être fixée sur l'une des bornes de la batterie du véhicule automobile.

L'autre partie 3 est configurée pour être reliée électriquement au câble de la batterie associé à la borne concernée de la batterie.

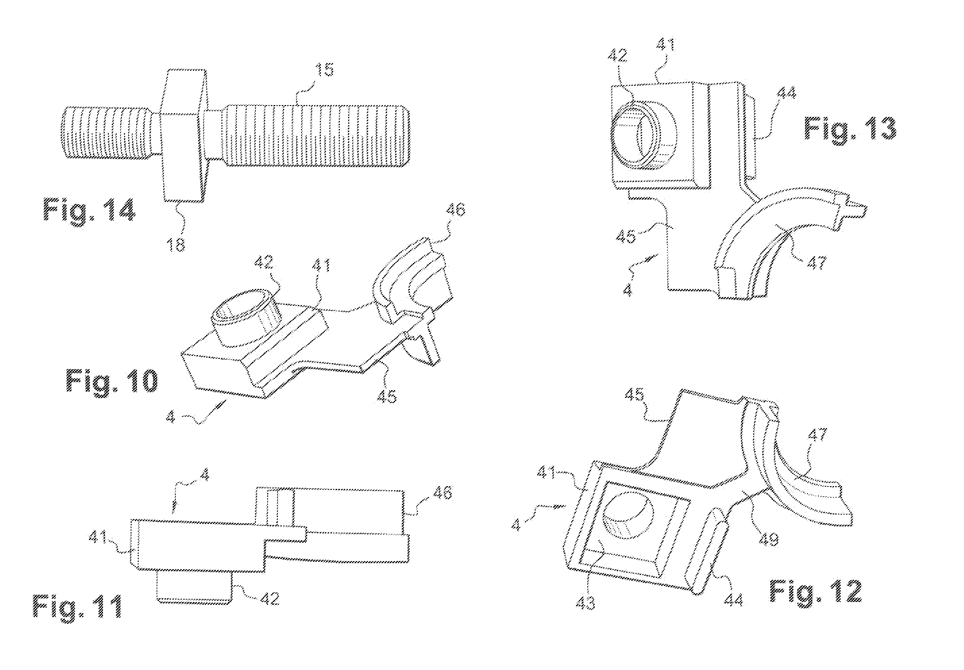

La première partie 2 porte à cet effet des moyens de fixation au câble de la batterie. Dans l'exemple de réalisation, de manière économique, ces moyens de fixation du câble appartiennent à des moyens d'assemblage 14, qui interviennent entre les deux parties 2, 3. Ces moyens d'assemblage 14 sont solidaires de la première partie 2 et traversent la deuxième partie 3. Ces moyens 14 comportent un goujon 15 doté (figure 14) d'une partie de serrage et de blocage en rotation 18 disposée entre deux parties filetées. La partie 18 est dans cet exemple de réalisation de section carrée.

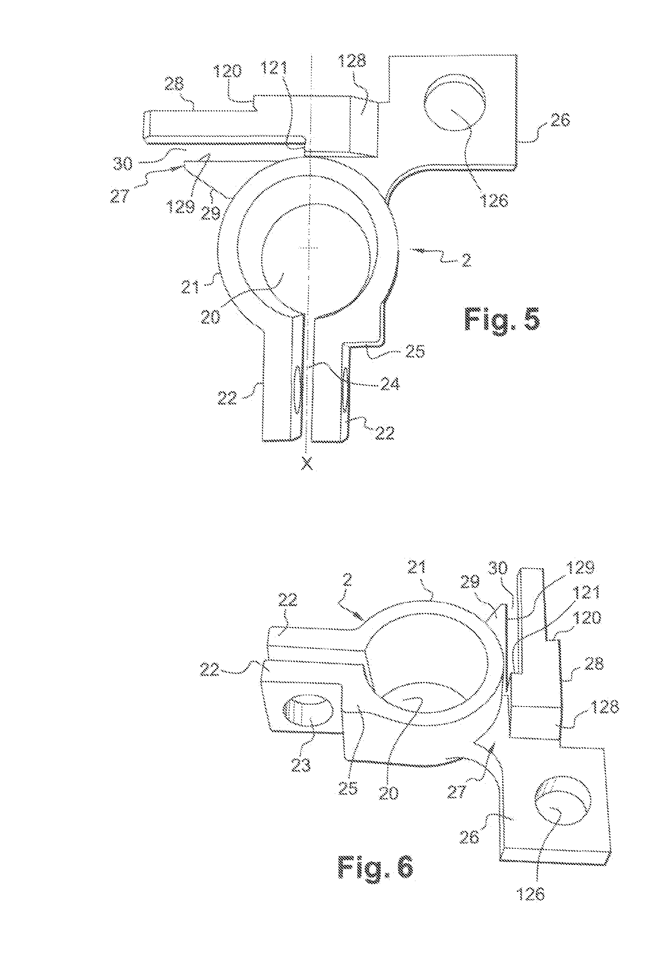

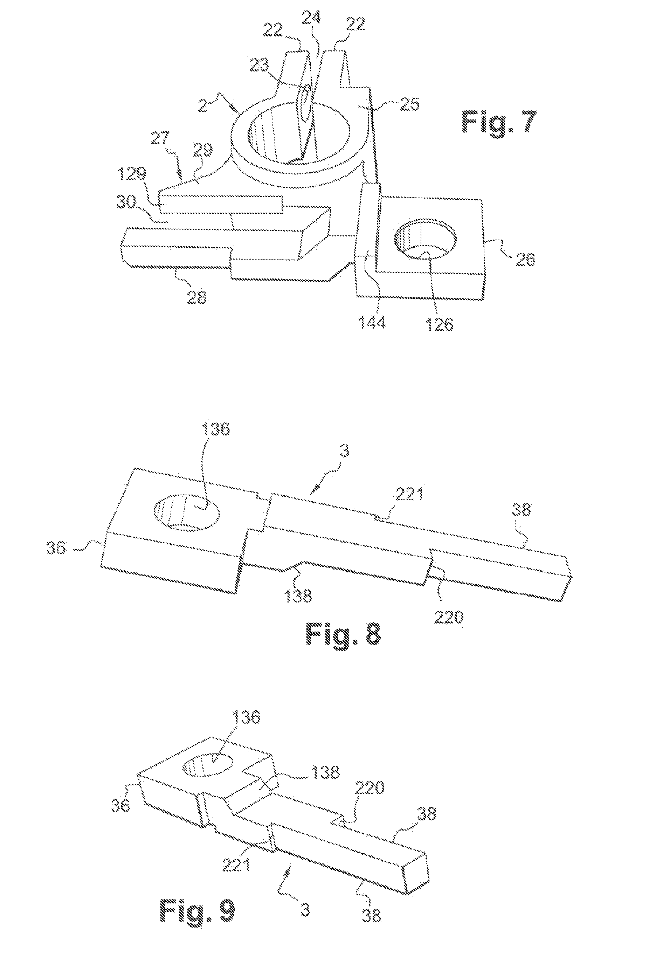

Les parties 2, 3 sont dotées chacune selon une caractéristique d'une patte d'assemblage 26, 36, ici de forme rectangulaire trouée pour passage de la partie filetée concernée du goujon 15. Les pattes 26, 36 sont visibles dans les figures 5 à 9 ; les trous, ici cylindriques, portant respectivement la référence 126, 136.

Les trous 126, 136 et les pattes 26, 36 sont implantées en vis-à-vis ; la patte 36 étant implantée au-dessus de la patte 26 de manière décrite ci-après.

Chacune de ces parties 2, 3 est configurée, de manière décrite ci-après, pour être fixée au shunt 7 et donc porter le shunt 7.

Des moyens d'isolation électrique 4, 17 interviennent selon une caractéristique entre les deux parties 2, 3 distinctes.

Ces moyens comportent ici une entretoise 4 en matière électriquement isolante et une rondelle électriquement isolante 17 décrite ci-après. Ces moyens 4, 17 présente des fonctions supplémentaires par rapport au manchon isolant du document FR 2 866 158 de manière décrite ci-après.

L'entretoise 4 est intercalée entre les deux parties 2, 3 pour notamment isoler le goujon 15, ici métallique et électriquement conducteur, par rapport à la patte 26.

Les deux parties 2, 3 sont électriquement et thermiquement conductrices et ont une fonction mécanique car elles sont également configurées pour être fixée mécaniquement respectivement à la borne et au câble concernés de la batterie. Les deux parties 2, 3 de la cosse 1 sont métalliques et présentent ici chacune une faible résistance électrique.

Les deux parties 2, 3 sont dans un mode de réalisation en matière différente.

Dans un autre mode de réalisation les deux parties 2, 3 sont de matière identique. Ces deux parties 2, 3 de la cosse 1 sont par exemple à base de laiton pour des raisons économiques. Ces parties sont dans un mode de réalisation étamées. En variante elles sont est en cuivre.

Ici les deux parties sont en matière moulable pour obtenir les formes voulues. Dans l'exemple de réalisation représenté les deux parties 2, 3 sont à base de laiton.

En variante l'une au moins des parties est usinée. Par exemple la deuxième partie 3, de forme plus simple que la première partie 2, présente une forme obtenue par usinage

Les parties 2, 3 seront appelée respectivement cosse inférieure et cosse supérieure car comme visible à la figure 1 la deuxième partie 3 s'étend au dessus de la partie 2.

Ici la cosse inférieure 2 est configurée pour être fixée sur la borne négative de la batterie, et la cosse supérieure 3 est configurée pour être reliée au câble de la batterie, dit câble de masse, relié à la masse du véhicule automobile. Bien entendu en variante la cosse inférieure 2 est configurée pour se fixer sur la borne positive de la batterie et la cosse supérieure 3 sur le câble positif de la batterie.

L'entretoise 4 est dans cet exemple de réalisation en matière plastique moulable pour obtenir de manière aisée des formes souhaitées.

Cette matière plastique est dans un mode de réalisation renforcée par des fibres.

L'entretoise 4 électriquement isolante est mieux visible dans les figures 10 à 13. Cette entretoise comporte une première partie 41 globalement de forme rectangulaire, dont la taille est adaptée à celle de la patte d'assemblage 26 de la cosse inférieure 2.

Cette partie 41 est dotée d'une cavité 43 (figure 12) trouée centralement. Le trou est constitué par l'alésage central d'un manchon 42, qui pénètre dans le trou 126 de la patte 26 de la cosse 2.

Ainsi qu'il ressort des dessins la partie filetée inférieure la plus courte du goujon 15 traverse le manchon 42 et est isolée électriquement par rapport à la cosse 2.

La partie 18 se loge dans la cavité 43 et est ainsi isolée électriquement par rapport à la patte 26. La partie 18 est saillante par rapport aux parties filetées du goujon 15

L'entretoise 4, intercalée entre les pattes 26, 36, est donc une entretoise d'isolation électrique interposée entre la partie 18 de serrage du goujon 15 et la patte 26.

La partie 18 est plus haute que la partie 41. Cette partie 18 est donc en contact électrique avec la face inférieure de la patte 36 de la cosse 3. La partie filetée la plus longue du goujon 15 traverse le trou 136 de la patte 36.

L'entretoise 4 isole électriquement la patte 26 par rapport au goujon 15 et donc par rapport à la patte 36 en contact électrique avec la partie 18 du goujon 15.

Les moyens d'assemblage 14 comportent également une rondelle 17, ici électriquement isolante, en contact avec la face inférieure de la patte 26 et un écrou 16 qui se visse sur l'extrémité de la partie filetée inférieure du goujon 15 en prenant appui sur la rondelle 17 isolante.

Les moyens d'isolation électrique 4, 17 comportent ainsi l'entretoise 4 et la rondelle 17, qui appartient selon une caractéristique aux moyens d'assemblage 14.

Le goujon 15 est donc fixé sur la patte 26 à l'aide de sa partie de serrage 18 en appui sur le fond de la cavité 43 en contact avec la face supérieure de la patte 26 et de l'écrou 16 en appui sur la rondelle 17 en contact avec la face inférieure de la patte 26. La partie saillante 18 forme donc une entretoise entre les deux pattes d'assemblage 26, 36 avec intervention du fond de la cavité 43 pour isoler électriquement les moyens d'assemblage 14 par rapport à la patte 26.

Il ressort de ce qui précède que le câble de batterie concerné, ici non visible, comporte dans un mode de réalisation, comme dans le document FR 2 910 719 , à son extrémité libre une rondelle ou une partie méplate trouée. Cette rondelle ou cette partie méplate est ici en contact électrique avec la face supérieure de la patte 36. Cette rondelle ou cette partie méplate est traversée par la partie filetée supérieure du goujon 15. Un écrou se vise sur l'extrémité de cette partie filetée supérieure pour serrer la rondelle ou la partie méplate du câble. La face inférieure de la patte 36 est en contact avec la partie de serrage 18.

En variante le câble présente à son extrémité libre une barre métallique trouée pour être traversée par la partie filetée supérieure du goujon 15. Le trou de la barre est dans une réalisation de forme cylindrique. En variante il est de forme oblongue.

La barre présente en variante plusieurs trous. Comme dans le précédent mode de réalisation un écrou se visse sur la partie supérieure filetée du goujon 15 pour serrer la barre d'extrémité du câble au contact de la patte 36, avec le cas échéant présence d'une rondelle entre l'écrou et la barre. Le goujon 15 appartient donc dans ces modes de réalisation aux moyens de fixation du câble de la batterie sur la cosse supérieure 3.

Comme visible dans les figures 1 à 4 et 12, la patte 26 et la partie 41 présentent chacune au niveau de l'un de leur bord une nervure de forme oblongue référencée respectivement en 144 et en 44. Les nervures 44, 144 s'étendent à 90° l'une par rapport à l'autre. La nervure 44 s'étend au dessus de la nervure 144. Cette nervure 44 est destinée à coopérer avec l'un des bords de la patte 36 de la cosse 3. Ainsi l'entretoise 4 est bloquée en rotation par la nervure 144. Le goujon 15 est bloqué en rotation via sa partie 18 engagée de manière complémentaire dans la cavité 43. La cosse 3 est bloquée en rotation par la nervure 44.

Bien entendu en variante la section de la partie 18 et de la cavité 43 ont une autre forme, par exemple hexagonale, ou circulaire avec au moins un méplat.

Les nervures 44, 144 sont en variante fractionnées.

En variante les nervures 44, 144 sont remplacées par au moins deux plots.

Dans tous les cas il est prévu des moyens de blocage en rotation par coopération de formes entre l'entretoise 4 et le goujon 15 et entre l'entretoise 4 et les cosses 2,3.

L'entretoise 4 présente donc également une fonction de blocage en rotation.

Il ressort de ce qui précède que l'on réalise, à la faveur des pattes d'assemblage 26, 36, un premier sous ensemble manipulable et transportable comprenant les cosses 2, 3, l'entretoise 4 et les moyens d'assemblage 14 avant le montage du shunt 7.

Suivant une autre caractéristique les cosses 2, 3 sont configurée pour porter un boîtier 5 de forme creuse fermé par un couvercle 6 pour formation d'un carter de forme creuse.

A cet effet les cosses 2, 3 présentent chacune une portion saillante 28, 38.

Ces portions saillantes 28, 38 portent à leur extrémité libre le shunt 7 et s'étendent globalement l'une au dessus de l'autre. Il en résulte que le shunt est, selon une caractéristique, de longueur réduite par rapport au shunt des documents FR 2 910 719 et DE 10 2004 055 847 précités.

Le shunt 7 est logé dans le boîtier 5 fermé par le couvercle 6 et est donc protégé. Le couvercle 6 s'étend parallèlement au fond 59 du boîtier 5, ici de hauteur constante.

Le boîtier 5 et le couvercle 6 sont dans cet exemple de réalisation en matière plastique moulable pour notamment obtenir de manière aisée des saillies d'appui de manière décrite ci-après.

Cette matière plastique est dans un mode de réalisation renforcée par des fibres.

Comme visible par exemple à la figure 20, le shunt 7, un support 8 de composants électroniques et des moyens de liaison électrique 9 entre le support 8 et le shunt 7 sont montés dans le boîtier 5 fermé par le couvercle 6.

Ainsi la cosse 1 présente une fonction supplémentaire de protection de ces composants 7, 8, 9 par rapport à celle du document FR 2 866 158.

On notera que le câble de la batterie concerné ne pénètre pas dans le boîtier 5.

Dans un mode de réalisation le boîtier 5 et le couvercle 6 forment un carter de forme parallélépipédique de section rectangulaire.

Ici le boîtier 5 et le couvercle 6, globalement de forme parallélépipédique, présentent, comme visible par exemple dans les figures 1 à 4, 15, 16, 17 et 20 chacun un fond respectivement 59, 159 et un bord vertical respectivement 259, 359 s'étendant ici perpendiculairement par rapport au fond 59, 159 et doté d'une portion biseauté, respectivement 51, 61, pour créer un dégagement 51, 61 au niveau des moyens de fixation 14.

Dans un autre mode de réalisation le carter 5, 6 est dépourvu de dégagements 51, 61 et est donc de forme parallélépipédique.

Les bords verticaux 259, 359 forment une ceinture perpendiculaire au fond 59, 159 et appartiennent aux corps respectivement du boîtier 5 et du couvercle 6. Le bord 259 est interrompu pour formation d'une ouverture latérale 55 décrite ci-après.

Dans ce mode de réalisation le boîtier 5 est plus profond que le couvercle 6, le bord 259 étant plus haut que le bord 359.

Dans un autre mode de réalisation le couvercle 6 est plus profond que le boîtier 5, le bord vertical du couvercle ayant par exemple la hauteur du bord 259, tandis que le bord vertical du boîtier a une hauteur égale à celle du bord 359

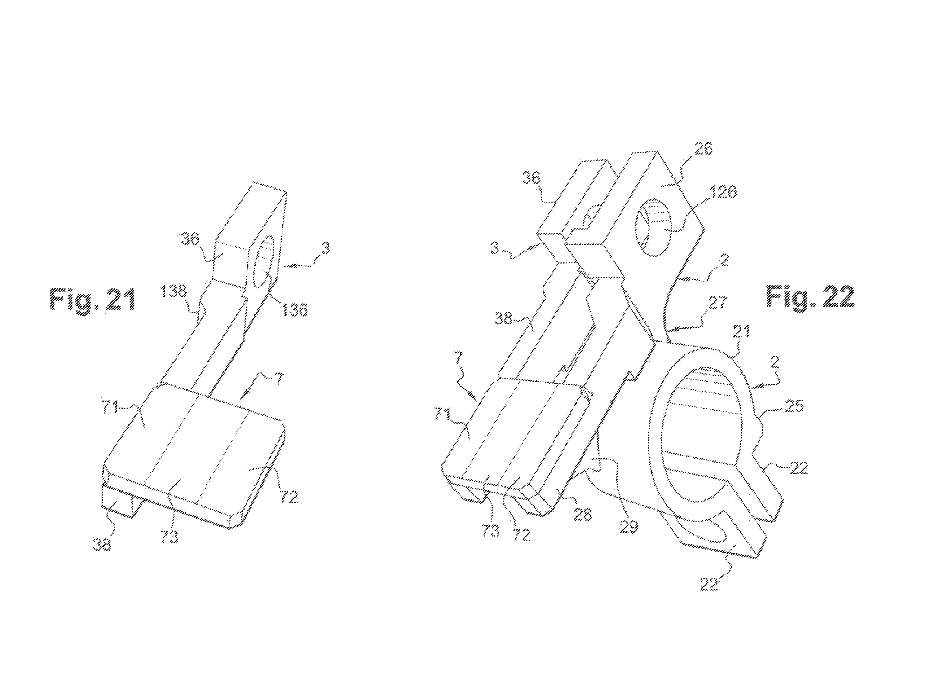

Le shunt 7 est électriquement conducteur. Sa résistance électrique est par définition faible. Le shunt 7 est en forme de plaque et comporte, comme visible dans les figures 21, 22 et 25, deux parties 71, 72 de raccordement électrique respectivement à la cosse 3 et à la cosse 2. Ces parties 71,72 présentent une bonne conductivité électrique. Elles sont par exemple à base de cuivre.

Ces parties 71, 72 sont séparées l'une de l'autre par une partie intermédiaire 73 en matériau plus noble ayant une grande stabilité en température. Cette partie 73 est par exemple en un alliage à base de manganin ou de constantin.

Pour plus de précisions sur le shunt on se reportera au document EP 0 605 800. Le shunt 7 est ici d'épaisseur constante. En variante l'épaisseur de la partie intermédiaire 73, pour des raisons économique, est inférieure à l'épaisseur des parties de raccordement. Le shunt 7 a une forme rectangulaire à bords arrondis. Dans l'exemple de réalisation le shunt est globalement de forme carrée.

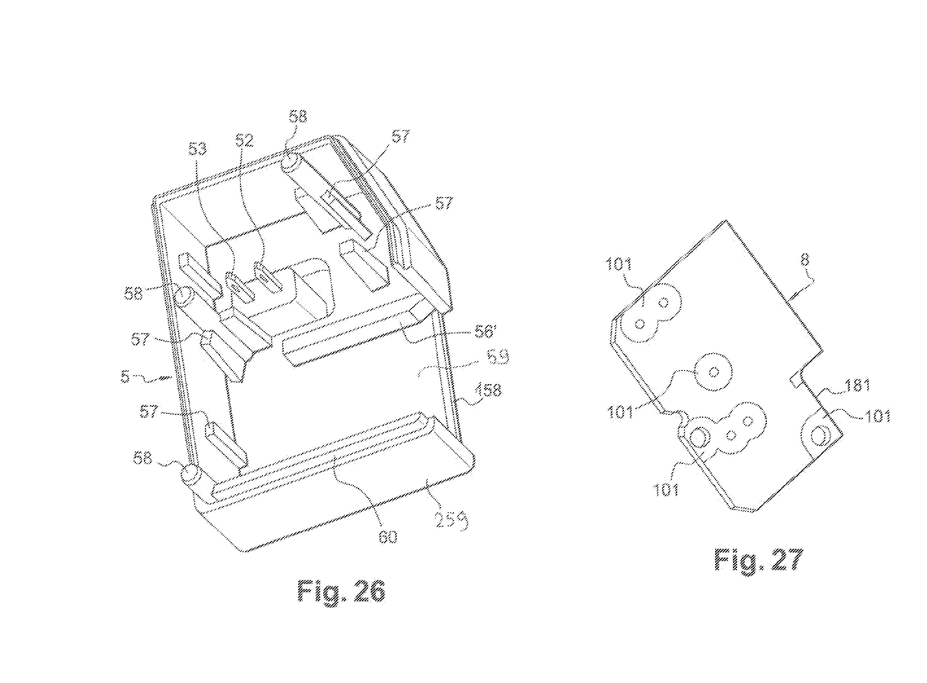

Le support 8 est en forme de plaque électriquement isolante portant des traces électriques. De telles traces sont visibles par exemple dans les figures 27 à 29 (voir références 101). Le support 8 est dans cet exemple de réalisation un circuit imprimé appelé PCB.

Suivant une caractéristique le support 8 est positionné dans ce mode de réalisation mécaniquement par le boîtier 5 et est en appui mécanique sur le boîtier 5 configuré en conséquence. Dans un mode de réalisation le support 8 est porté à fixation et immobilisé de manière décrite ci-après, par le couvercle 6 et le boîtier 5.

Ainsi le support 8 a ici une forme globalement rectangulaire présentant un bord doté d'un dégagement pour s'adapter intérieurement à la forme des portions biseautées 61, 51 du couvercle 6 et du boîtier 5.

Dans le mode de réalisation de la figure 19 le dégagement 81 a une forme biseauté pour s'adapter à la périphérie interne de la portion biseautée 51 du bord 259 du boîtier 5.

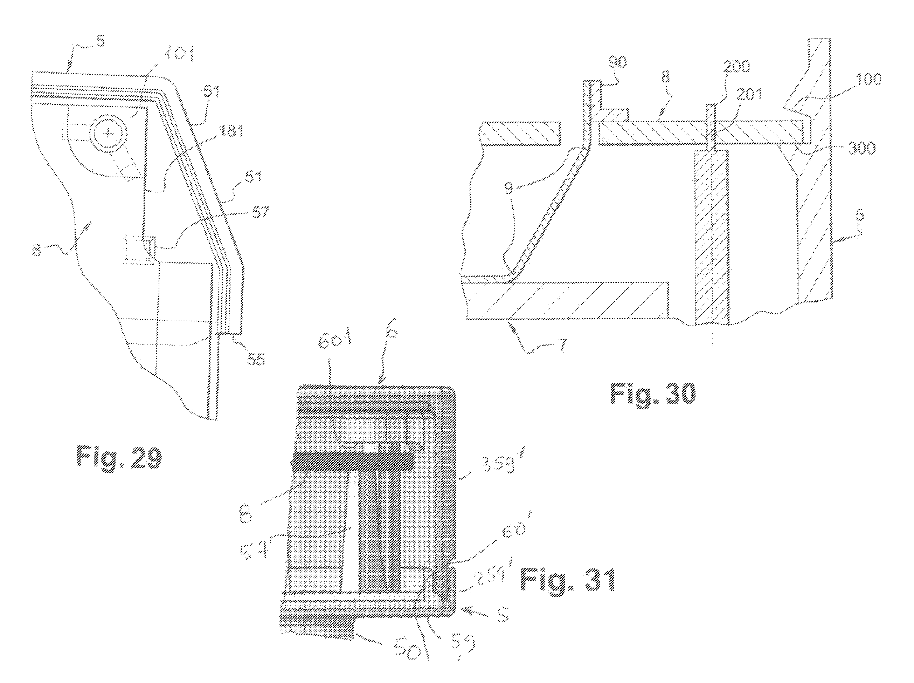

En variante comme visible dans les figures 27 et 29, le dégagement 181 du support 8 est en forme d'équerre pour économiser plus de matière.

Ce support 8 porte ici des composants électroniques notamment un circuit intégré de traitement des signaux et au moins un capteur relié au circuit intégré.

La nature des composants électroniques, de ou des capteurs et du circuit intégré de traitement des signaux dépend des applications. Pour plus de clarté on n'a pas représenté ces composants sachant que ceux-ci sont portés par la face supérieure du support comme représenté schématiquement dans le document FR 2 866 158.

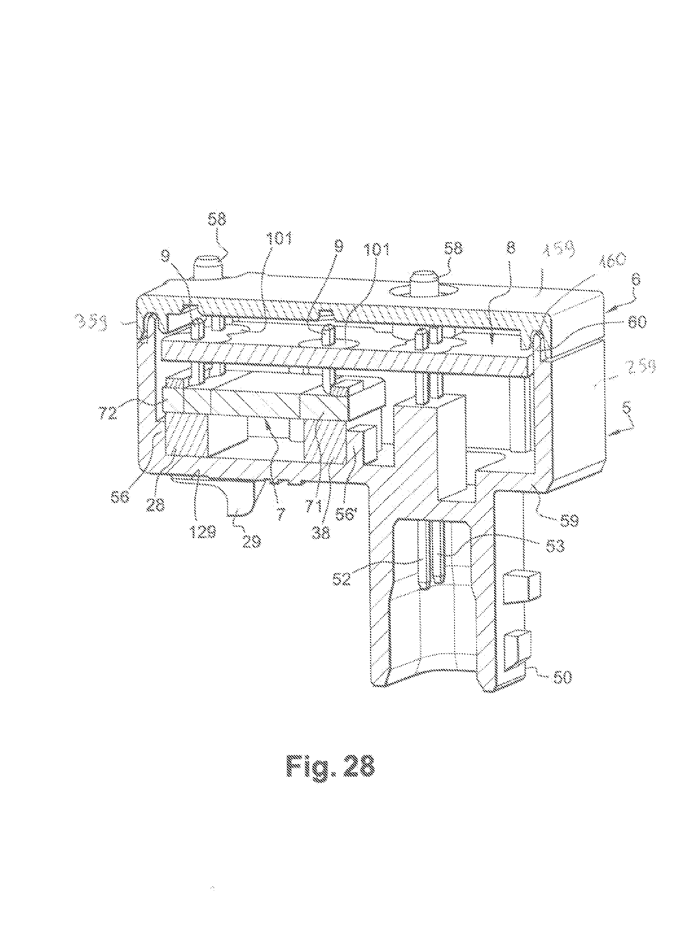

Le shunt 7 s'étend ici en dessous du support 8 de plus grande longueur que le shunt (figures 20 et 28).

La cosse 1, équipée du support 8 portant par exemple d'un circuit intégré, transmet des informations par exemple à un afficheur comme décrit dans le document WO 96/33078, ou à un calculateur tel que le calculateur du contrôle moteur du véhicule, ou à un alternateur, ou à un alterno-démarreur, ou à un régulateur de tension de l'alternateur ou à un système de démarrage du véhicule doté d'un démarreur et /ou d'un alterno-démarreur pour autoriser ou non le démarrage du véhicule automobile.

Pour mémoire on rappellera qu'un alterno-démarreur est un alternateur réversible qui fonctionne également en mode moteur électrique pour au moins de démarrer le véhicule automobile.

Tout cela dépend de manière précitée des applications

La cosse 1 est configurée pour mesurer au moins un paramètre de la batterie. Dans cet exemple de réalisation la cosse est configurée pour mesurer au moins le courant de la batterie via le shunt 7.

Ici il est prévu en outre un capteur de température qui transmet des informations au circuit intégré. Ce capteur de température comporte une sonde placée en vis-à-vis de la partie intermédiaire 73 du shunt 7.

Des moyens de liaison électrique 9, visibles par exemple dans les figures 18, 20, 25, 28 et 30, interviennent entre le shunt 7 et des traces électriques du support 8. Les moyens 9 comportent au moins deux éléments électriquement conducteurs. Un premier de ces deux éléments intervient entre l'une des parties de raccordement 71, 72 du shunt 7 et une première trace électrique du support 8. L'autre de ces deux éléments conducteurs intervient entre l'autre partie de raccordement 72, 71 du shunt et une deuxième trace électrique du support 8. La première et la deuxième trace sont reliées au circuit intégré. A partir de cela, de manière connue, on peut en déduire la tension entre les deux parties de raccordement 71, 72 du shunt 7 et donc le courant de la batterie, qui est proportionnel à la tension entre les deux parties de raccordement 71,72 du shunt 7.

Dans les figures 18, 20, 25, les éléments des moyens 9 consistent en des ressorts métalliques de forme ondulée. Ces ressorts sont par exemple soudés respectivement sur la partie 71 et sur la partie 72.

En variante les ressorts sont soudés sur les traces électriques du support 8. Dans le mode de réalisation de la figure 28 les éléments ont une forme en L avec une base soudée sur la partie 71, 72 concernée et une tête élastiquement déformable en forme de pointe destinée à établir un contact électrique par fixation dans une perforation métallisée du support 8 appartenant à une trace conductrice. Cette tête de forme oblongue et bombée présente une ouverture de forme oblongue délimitée par deux branches de contact bombées. Lors de l'insertion dans la perforation les deux branches sont mises sous précontrainte et se rapprochent donc l'une de l'autre pour établir un contact électrique avec des bords de la perforation.

Un tel assemblage est appelé assemblage du type press-fit.

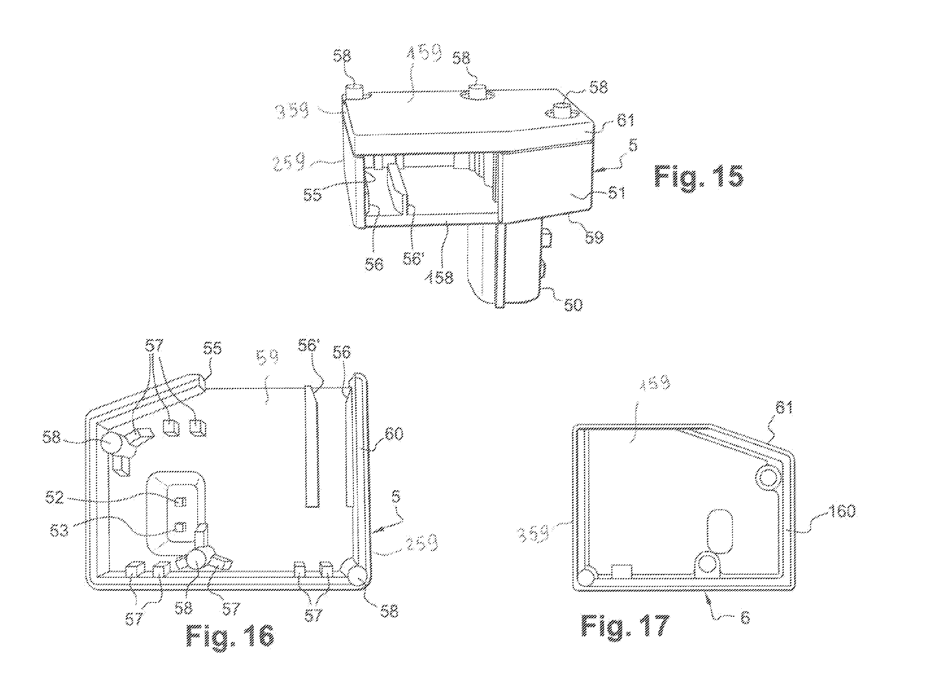

Cette tête peut être épaulée comme visible par exemple dans la figure 17 du document US 3 634 819.

Avantageusement la tête des éléments est dépourvue d'épaulement car le support est au moins positionné mécaniquement par le boîtier du carter, voir immobilisé mécaniquement par le carter via son boîtier et son couvercle. Les éléments des moyens 9 sont donc simplifiés.

Dans la figure 30 les moyens 9 consistent en une lame souple électriquement conductrice soudée sur le shunt et sur une pièce 90 soudée sur la face supérieur du support 8. L'élément 9 traverse pour ce faire une ouverture 91 du support.

Toutes ces variantes sont rendues possibles par le fait que suivant une caractéristique le support 8 est positionné ou immobilisé mécaniquement de manière décrite ci-après, dans le carter formé par le boîtier 5 et le couvercle 6. Les moyens 9 n'ont pas ainsi de fonction mécanique. Ils ne portent pas le support 8

Le circuit intégré du support 8 comporte dans un exemple de réalisation un convertisseur analogique/numérique, un circuit d'amplification et/ou un microprocesseur et/ou un circuit de compensation de la température comme décrit par exemple dans les documents EP 1 030 185 et EP 0 990 167.

Dans le document EP 0 990 167 il est prévu deux fils électriquement conducteurs, qui partent de la cosse. L'un de ces fils se branche sur l'autre borne de la batterie pour alimentation électrique des composants électroniques portés par le support 8. L'autre des fils constitue un fil de transmission des données, par exemple à un afficheur, ou à un calculateur, tel que le calculateur du contrôle moteur du véhicule, ou à un alternateur, ou à un alterno-démarreur ou à un régulateur de tension de l'alternateur ou de l'alterno-démarreur ou au dispositif de démarrage du véhicule.

Dans une réalisation la cosse 1 est équipée de tels fils qui sortent du boîtier 5.

Dans le mode de réalisation représenté dans les figures les fils électriques précités ne sortent pas du boîtier 5 mais se branchent sur un connecteur à broches appartenant au boîtier 5. Les extrémités de ces broches traversant le support 8 sont référencées en 52 et 53 dans les figures 16, 18, 19, 25.

Les broches sont saillantes en direction de la cosse 2 et sont protégées pour ce faire par une partie saillante 50 du boîtier 5 venue de moulage avec ce boîtier. Cette partie saillante 50 entoure les broches pour formation ici d'un connecteur du type mâle. La partie 50 est issue de moulage du fond 59 du boîtier 5 et s'étend en direction de la cosse 2.

Un connecteur complémentaire, ici du type femelle, comportant les deux extrémités des fils précités se branche sur ce connecteur à broches du boîtier.

Bien entendu en variante on peut inverser les structures ; le connecteur du boîtier étant du type femelle et le connecteur complémentaire du type mâle.

La cosse 1 est configurée, suivant une caractéristique, pour porter le carter 5, 6 et permettre un montage aisé par enfilage du boîtier 5. Cette cosse 1 permet ainsi de réduire la quantité de matière du carter 5, 6 et de faciliter le montage du boîtier.

Comme visible par exemple dans les figures 5 à 7, la cosse inférieure 2 comporte une partie de serrage dotée de pattes de serrages et d'une ouverture 20 pour se monter autour de la borne concernée de la batterie du véhicule. Comme décrit dans le document FR 2 866 158, l'ouverture 20 est délimitée par une zone annulaire 21 prolongée par les deux pattes saillantes 22 de serrage en vis-à-vis. Ces pattes 22 sont ici parallèles entre elles et d'orientation transversale par rapport à la zone 21.

Le centre de l'ouverture 20 et de la zone 21 constitue le centre de la partie de serrage 21, 22.

Les pattes 22 sont dotées chacune d'un trou 23 et sont séparées l'une de l'autre par une fente 24. Il est ainsi formé une pince de serrage, les pattes de serrage 22 pouvant être écartées l'une de l'autre pour montage de zone 21, à la faveur de son ouverture 20, sur la borne, usuellement de forme tronconique, de la batterie. Ensuite on enfile des moyens de serrage 11 dans les trous 23 en correspondance pour rapprocher les pattes 22 et serrer la borne de la batterie montée dans l'ouverture 20.

Les moyens de serrage 11, ici métalliques, consistent ici (voir figures 1 et 2) en un boulon avec une vis dotée d'une tête 12 globalement de forme carrée en variante de forme polygonale. La tête 12 de la vis prend appui sur la face extérieure de l'une des pattes 22 et est immobilisée en rotation par coopération de formes avec une surépaisseur 25, que présente la cosse inférieure 2 au niveau de la zone d'enracinement de la patte 22 concernée avec la zone annulaire 21.

La partie filetée de la vis traverse les trous 23. L'écrou du boulon prend appui sur la face extérieure de l'autre patte 22 avec ici interposition d'une rondelle 13 (figure 2). Lorsque l'on visse l'écrou on rapproche les pattes 22 l'une de l'autre pour réaliser un serrage de la cosse 2 via sa zone 21 autour de la borne de la batterie. Comme visible par exemple dans les figures 2, 4 et 23, la partie saillante 50 du boîtier 5 s'étend perpendiculairement par rapport au fond 59 du boîtier 5 et parallèlement aux branches 22 en étant décalée par rapport à l'ouverture 20.

La zone annulaire 21, ouverte au niveau des pattes 22, a dans cet exemple de réalisation globalement la forme d'un manchon 21 de serrage fendu.

La cosse inférieure 2 présente également, du côté diamétralement opposé aux pattes 22 et donc à la fente 24 du manchon 21, une protubérance 27 qui se raccorde au manchon 21. La protubérance 27 est ici venue de moulage avec le manchon 21. Elle s'étend perpendiculairement au manchon 21 et est donc d'un seul tenant avec le manchon 21. En variante la protubérance 27 est solidaire du manchon 21 par exemple par soudage.

Cette protubérance 27 s'étend dans un plan perpendiculaire à celui des pattes de serrage 22 entre la périphérie externe et la périphérie interne du manchon 21.

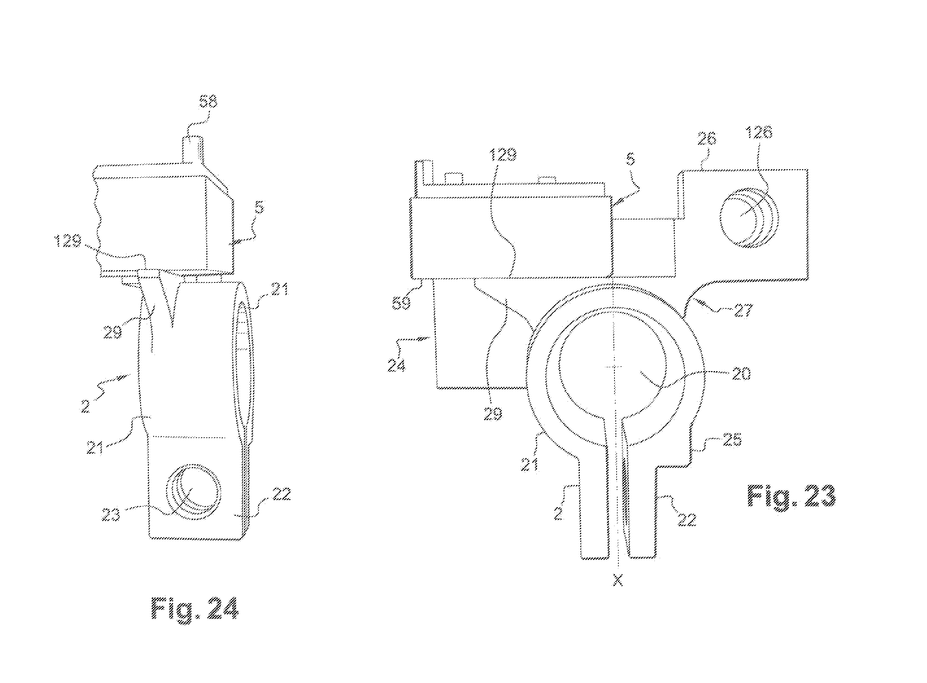

La patte d'assemblage 26 précitée appartient à la protubérance 27, ici en forme de voile. La patte 26 est donc ici d'un seul tenant avec la protubérance 27. Cette protubérance 27 comporte suivant une caractéristique un support de soutien 29 du boîtier 5 de manière décrite ci-après Le support 29 à une forme pointue. Il est ici de forme triangulaire. La patte d'assemblage 26 et le support de soutien 29 s'étendent de part et d'autre de l'axe de symétrie X (figures 5 et 23) des pattes 22 passant par le milieu de la fente 24 et le centre de l'ouverture 20.

Ainsi la patte 26 et le support 29 s'étendent de part et d'autre du manchon 21.

La patte d'assemblage 26 est trouée centralement en 126 pour passage de manière précitée de la partie inférieure filetée du goujon 15.

Un bras épaulé 28 se raccorde à la patte 26 par une portion inclinée 128 en direction de la périphérie interne du manchon 21 en sorte que le bras 28 est décalé par rapport au support 29. Le bras 28 est saillant par rapport à la patte 26 et est dirigé en direction du support 29. Ce support de soutien 29 s'étend donc en surélévation par rapport au bras 28 et ce en direction de la périphérie externe du manchon 21. La portion saillante de la première partie 2 est donc constituée ici par le bras 28, La patte 26 est ici d'un seul tenant avec le bras 28, la portion inclinée 128 et la protubérance 27.

La périphérie externe 129 du support 29 consiste en une surface usinée qui s'étend perpendiculairement à l'axe X et parallèlement au bras 28 également usiné. La périphérie interne du bras 28 est tournée vers la surface 129.

Une fente 30, ici de largeur constante, existe donc entre la périphérie externe 129 du support 29 et la périphérie interne du bras 28.

Selon une caractéristique de l'invention le carter 5, 6 comporte une ouverture latérale 55.

L'ouverture latérale 55 est formée dans l'un au moins des bords verticaux 259, 359.

Plus précisément dans les modes de réalisation des figures 1 à 30 le boîtier 5 comporte latéralement une ouverture borgne 55 formée dans son bord vertical 259 et fermée par le couvercle 6 (figures 15, 16, 18 à 20 et 25) pour former une ouverture rectangulaire 55 dont les grand côtés sont constitués par le couvercle 6 et par le bord 158 parallèle du fond 59 du boîtier 5.

Le bras 28 saillant, constituant une portion saillante de la première partie 2, est configuré pour pénétrer dans l'ouverture 55 du boîtier 5. La périphérie interne du bras 28 coopère avec la face interne du fond 59. Cette périphérie interne est d'épaisseur étagé en sorte qu'il est formé un épaulement 121 (figures 5 et 6) destiné à venir en appui contre le bord 58 du fond 59.

La longueur entre l'épaulement 121 et l'extrémité libre du bras est fonction de la profondeur du boîtier 5 pour ne pas interférer avec celui-ci.

La largeur de la fente 30 est fonction de l'épaisseur du fond 59. Elle est globalement égale à l'épaisseur du fond 59. Les bords de la fente 30 sont décalés comme visible dans les figures 5 à 7.

Cette largeur 30 est égale ici au jeu de montage près à l'épaisseur du fond 59. Ainsi, comme mieux visible dans les figures 23 et 24, la face externe du fond 59 est en contact avec la périphérie externe 129 du support 29, qui ainsi selon une caractéristique soutient le boîtier 5.

La périphérie interne du bras 28 est destinée à venir en contact avec la face interne du fond 59.

Le boîtier 5 est, selon une caractéristique, monté simplement par enfilage à la faveur de son ouverture latérale 55 dans la fente 30. Ce mouvement d'enfilage est limité par venue en butée du bord 158 contre l'épaulement 121.

Le décalage entre le support 29 et le bras 28 permet une stabilité du montage, plus précisément s'oppose à un mouvement de basculement du boîtier 5.

Les bords latéraux du bras 28, globalement de section rectangulaire, participent au maintien et à la stabilisation du boîtier 5 présentant pour ce faire deux nervures parallèles 56, 56' (voir par exemple figures 15 et 16) entre lesquelles s'engage les faces latérales de l'extrémité du bras 28.

Les nervures 56 et 56' constituent donc des rails de guidage pour le montage du boîtier par enfilage dans la fente 30. Ces nervures 56, 56' rigidifient également le fond 59 et le bord latéral du boîtier 5, le plus éloigné de la portion 51, car la nervure 56 est adjacente à ce fond.

La hauteur des nervures est de préférence inférieure ou globalement égale à la hauteur de l'extrémité du bras 28 car la périphérie externe du bras 28 porte le shunt 7 fixé par soudage sur la périphérie externe du bras 28.

Le shunt 7 est en butée sur l'épaulement 120 décalé par rapport à l'épaulement 121 en direction de l'extrémité libre du bras 28.

Le shunt 7 est ici fixé par soudage sur l'extrémité libre du bras 28.

Plus précisément la partie de raccordement 72 du shunt 7 est fixée par soudage sur la périphérie externe du bras 28.

Le soudage du shunt 7, en appui sur la périphérie externe du bras 28, est réalisé à l'aide d'une électrode prenant appui sur la périphérie interne du bras 28.

Cela est rendu possible du fait que suivant une caractéristique le support de soutien 29 est décalé par rapport au bras 28 pour autoriser le passage de l'électrode de soudage du shunt 7 sur le bras 28.

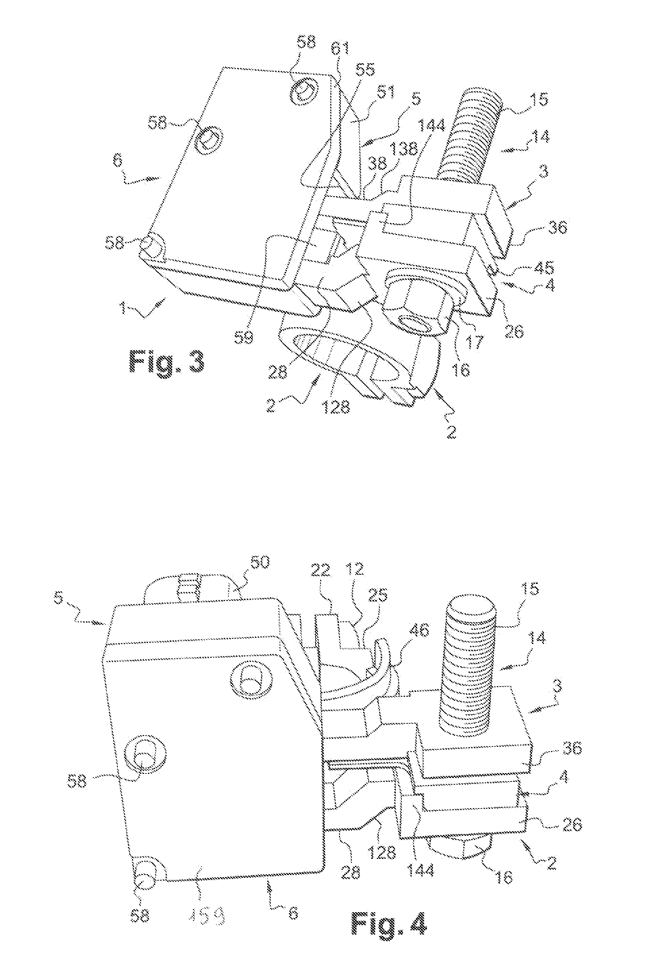

La cosse supérieure 3 (figures 3, 8, 9,21) présente un bras 38 saillant de forme semblable au bras 28. Ce bras 38 constitue la portion saillante de la deuxième partie 3.

Le bras 38, globalement de section rectangulaire, est raccordé à la patte d'assemblage 36 précitée par une portion inclinée 138 en sorte que le bras est décalé par rapport à la patte 36. Le bras 38 est configuré pour pénétrer dans l'ouverture latérale 55.

Le bras 38 présente un épaulement 221 au niveau de sa périphérie interne pour venir en butée contre le bord 58 de l'ouverture 55. Il présente au niveau de sa périphérie externe un épaulement 220 pour le shunt.

Le shunt 7 est en butée sur l'épaulement 220 décalé par rapport à l'épaulement 221 en direction de l'extrémité libre du bras 38.

Le soudage du shunt 7, en appui via sa partie de raccordement 71 sur la périphérie externe du bras 38, est réalisé à l'aide d'une électrode prenant appui sur la périphérie interne du bras 38.

La périphérie interne du bras est destinée à venir en contact avec la face interne du fond 59.

Ainsi qu'on l'aura compris on équipe les cosses 2, 3 des moyens d'assemblage 14 et de l'entretoise 4, puis du shunt 7 par soudage avant de monter ce sous ensemble 2, 3, 14, 4, 7 manipulable et transportable dans le boîtier 5 par enfilage.

Bien entendu en variante les parties 71, 72 du shunt 7 sont fixées par brasage ou collage sur les extrémités libres des bras 38, 28. Le shunt 7

Il résulte de ce qui précède que selon une caractéristique le carter 5, 6 présente une ouverture latérale 55 dans laquelle pénètre deux portions saillantes 28, 38 des deux parties 2, 3 de la cosse 1. Plus précisément les deux parties 2, 3 présentent à cet effet chacune un bras 28, 38 saillant de support du shunt 7, qui pénètre dans le boîtier 5.

Les bras 28 et 38 sont globalement de même taille et étagés en épaisseur comme visible à la figure 22, dans laquelle on a représenté que les cosses 2, 3 et le shunt 7 pour plus de clarté.

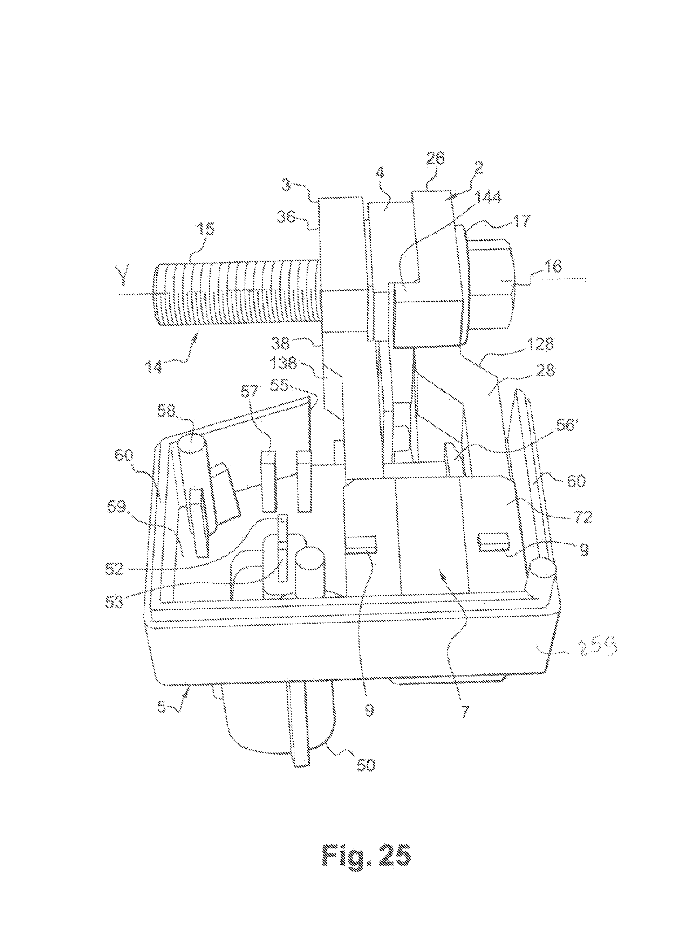

Les bras 28, 38 sont parallèles comme visible dans les figures 22 et 25 et constituent les deux portions saillantes des deux parties 2, 3 implantées globalement l'une au dessus de l'autre par rapport à l'axe Y (Figure 25) du goujon 15 des moyens d'assemblage 14.

Comme visible dans ces figures 22 et 25 les périphéries externes des extrémités des bras 28, 38 sont dans le même plan en sorte que le shunt 7 s'étend parallèlement à l'axe Y du goujon 15 des moyens d'assemblage 14.

La distance entre les bras 28, 38 dépend de la largeur de la partie intermédiaire 73.

Cette distance est égale au moins à la largeur de la partie intermédiaire.

On appréciera la souplesse de la disposition car les bras 28, 38 s'étendent en porte à faux par rapport aux pattes d'assemblages 26, 36 et ce à distance du manchon 21 et de la protubérance 27.

Tout ceci est avantageux car cela permet de minimiser la transmission des vibrations du manchon 21 au shunt 7.

Cela permet également de limiter les sollicitations mécaniques, notamment lors du serrage de la cosse inférieure 2 sur la borne de la batterie, car les pattes de serrages 22 sont éloignées des pattes 26, 36 . En outre une fente 30 existe au niveau du bras 28.

On appréciera que la matière du carter 5, 6 est réduite du fait que les extrémités libres des bras 28, 38 et le shunt pénètrent dans le carter 5, 6 à la faveur de l'ouverture 55. Le carter n'est pas surmoulé sur le manchon 21 en sorte que la solution est économique.

Le carter 5, 6 est décalé par rapport à l'axe X.

Les moyens d'assemblage 14 et le carter 5, 6 s'étendent globalement de part et d'autre du plan X.

On appréciera que le shunt 7 a une faible longueur et est distinct de la zone de fixation respectivement du câble concernée de la batterie et à la borne concernée de la batterie. Ce shunt 7 est éloigné des pattes d'assemblage 26, 36 et des moyens d'assemblage 14. Il est donc ménagé mécaniquement. Ainsi la partie de raccordement 71 du shunt 7 peut être dans un mode de réalisation en matière différente de celle du bras 38. De même la partie de raccordement 72 du shunt peut être dans un mode de réalisation différente de celle du bras 28. Le shunt 7 s'étend globalement parallèlement au manchon 21 et perpendiculairement à la protubérance 27.

Dans la figure 25 on a représenté également l'entretoise 4 et les moyens d'assemblage 14.

Cette entretoise 4 (figures 10 à 13) présente également un voile 45 de liaison de la partie 41 à une autre partie 46 en forme de secteur annulaire.

Ce secteur est étagé et comporte une zone plane 47 de raccordement entre deux jupes (non référencée) décalées l'une par rapport à l'autre. L'une de ces jupes, de hauteur inférieure à l'autre, est destinée à venir en contact avec la périphérie externe du manchon 21 (figure 1 et 2).

L'autre jupe masque en partie le bras 38. En cas de vibrations une isolation électrique entre les deux cosses 2 et 3 est ainsi réalisée.

Des nervures 49 renforcent le voile s'étendant à la périphérie externe de la partie 41 et au dessus de la nervure 144.

L'entretoise 4 a donc une autre fonction supplémentaire.

On notera que les bras 28, 38 s'étendent perpendiculairement par rapport aux pattes 22. Les pattes 22 sont ici parallèles entre elles. En variante les pattes 22 sont vrillées comme visible dans le document FR 2 866 158. Dans tous les cas le manchon de serrage 21 est fendu et la protubérance 27 est globalement diamétralement opposée à la fente du manchon 21; la patte 26 et le support de soutien 29 s'étendant de part et d'autre du manchon 21.

On appréciera, notamment à la lumière de la figure 2, la compacité de la cosse 1 car le carter, comprenant le boîtier 5 fermé par le couvercle 6, est décalé par rapport aux pattes 36, 26, tandis que le boulon 11 s'étend parallèlement aux bras 38, 28 et le goujon 15 parallèlement au carter 5, 6 et perpendiculairement au boulon 11.

Le carter 5, 6 s'étend selon une caractéristique perpendiculairement à la protubérance 27.

Bien entendu la taille de l'ouverture latérale 55 dépend de l'écartement entre pour que les bras 28, 38 équipés du shunt 7 puissent pénétrer dans le boîtier 5.

Le carter 5, 6 comporte un réseau de saillies verticales 57 pour appui de la face interne du support 8 sur les extrémités libres des saillies 57. Ces saillies constituent des moyens d'appui mécanique pour le support 8.

L'un au moins des bords verticaux 259, 359 sert à positionner mécaniquement le support 8 par coopération de formes.

Plus précisément dans les figures 16 , 25, 26 le boîtier 5 comporte un réseau de saillies verticales 57 pour appui de la face interne du support 8 sur les extrémités libres des saillies 57 issues, ici par moulage, du fond du boîtier 5. Les saillies 57 constituent des moyens d'appui mécanique du support 8. Ces saillies 57 sont issues du fond du boîtier 5 et s'étendent perpendiculairement au fond.

La périphérie externe du boîtier 5 présente un rebord 60 saillant appartenant au bord vertical 259 pour pénétrer dans une rainure 160 (figures 17 et 28) creusée dans le bord verticale 359 du couvercle 6. Plus précisément le rebord 60 et la rainure 160 appartiennent à la périphérie respectivement externe et interne des bords verticaux 259, 359 du boîtier 5 et du couvercle 6. Le rebord 60 s'étend en saillie verticale par rapport au bord vertical 259 du boîtier 5 avec formation d'un épaulement, non référencé et mieux visible à la figure 26, pour appui éventuel de la face interne du rebord vertical du couvercle 6. Des colonnettes 58, ici au nombre de trois, sont prévues pour positionner mécaniquement le couvercle par rapport au boîtier 5 afin que le rebord 60 pénètre dans la rainure 160. Les colonnettes 58 s'étendent perpendiculairement par rapport au fond du boîtier comme visible dans les figures 16,18, 25, 26. Ces colonnettes traversent le couvercle 6 comme visible par exemple dans les figures 3 et 4.

Deux des colonnettes 58 (figure 19) servent également à positionner mécaniquement le support 8 par rapport au couvercle 6. Plus précisément ces deux colonnettes 58 sont pourvues de saillies 57 moins hautes verticalement que les colonnettes 58. Les saillies 57 constituent des nervures de rigidification de ces deux colonnettes 58 et des appuis mécaniques pour le support 8. La face interne du bord vertical du boîtier, appartenant au corps du boîtier, participe à l'immobilisation mécanique du support 8 par coopération de formes. Ces deux colonnettes 58 traversent également des ouvertures du support 8 dans le mode de réalisation de la figure 19. Elles appartiennent donc, tout comme la face interne du bord vertical 259 du boîtier 5, aux moyens pour positionner mécaniquement le support 8.

Le couvercle 6 est troué pour le passage des broche 52, 53.

En variante, comme visible à la figure 28, Les broches 52, 53 ont une tête analogue à celle des têtes des élément 9 pour un montage précité du type press-fit.

Ainsi qu'il ressort de la description du mode de réalisation et des figures 1 à 25, le support 8, sous forme de circuit imprimé, vient via sa face interne en appui sur les sommets des saillies d'appui 57 et est en contact par sa face supérieure avec la périphérie interne du bord 359 du couvercle 6 contenant la rainure 160.

Le support 8 est donc selon une caractéristique, dans ces modes de réalisation, porté à solidarisation mécanique par le carter 6, 5 en sorte que les moyens de liaison électriques 9 n'ont pas de fonction mécanique de support du support 8 comme dans le document FR 2 866 158.

Le support 8 est donc bloqué dans le carter 5, 6 et centré dans celui-ci notamment grâce aux colonnettes 58.

Bien entendu un jeu existe entre le fond de la rainure 160 et l'extrémité du rebord transversal 60 pour autoriser un appui du couvercle 6 sur le support 8 et immobiliser celui-ci. De même un léger jeu existe entre la périphérie interne du rebord 359 et la périphérie externe du rebord 259.

Cette disposition permet un grand nombre de formes de réalisation pour les éléments des moyens 9.

Il ressort également de la description et des dessins que le support 8 est monté après la mise en place du boîtier 5 sur les cosses 2, 3.

En considérant la figure 25 on voit que le support 8 est monté ultérieurement sur les saillies d'appui 57, le couvercle 6 étant monté en final.

Suivant une caractéristique on rempli en final le carter 5, 6 équipé de résine de protection électriquement isolante.

Dans un mode de réalisation, le couvercle 6 étant assemblé avec le boîtier 5, on remplit de résine non encore polymérisée le carter 6, 5 équipé du shunt 7 et du support 8, par l'ouverture 55.

En variante on bouche à l'aide d'un outil l'ouverture 55 et on remplit le boîtier 5 équipé du shunt 7 et du support 8 de résine non encore polymérisée par le haut, puis on fixe le couvercle 6 sur le boîtier 5.

Tout cela est rendu possible par le fait que des dégagements sont présents entre le boîtier 5 et le support 8, comme visible à la figure 19, Ces dégagements permettent le passage de la résine.

Ces dégagements sont réalisés notamment à la faveur de deux coins chanfreinés du support 8, par la présence d'une ouverture borgne du support 8 et par le fait que le dégagement 81 du support 8 est à distance du bord 51 comme visible à la figure 19.

En variante, à la figure 25, le dégagement 181 facilite encore plus le passage de la résine.

Ici la résine de protection des composants contenus dans le carte, présente une fonction supplémentaire car après polymérisation elle fixe le carter 5, 6 par rapport aux deux cosses 2, 3.

Grâce à l'invention le boîtier 5 est donc tenu par les cosses 2, 3, tandis que le support 8, en forme de circuit intégré, est tenu par le carter 5, 6, c'est à dire centré et bloqué par le boîtier 5 via les saillies 57, les colonnettes 58 et le couvercle 6. Le tout est rempli de résine pour bloquer mécaniquement le boîtier équipé sur les cosses 2, 3 et protéger les constituants internes au carter 5, 6 contre les attaques des agents extérieurs.

Bien entendu dans un mode de réalisation on écrase à chaud les extrémités des colonnettes 58 pour réaliser une liaison par rivetage entre le couvercle et le boîtier.

En variante on soude le couvercle 56 sur le boîtier 5. Le soudage est dans un mode de réalisation un soudage à ultrasons.

En variante comme visible dans les figures 27 et 28, le support 8, traversé par deux des colonnettes 58, est en appui sur les saillies 57, dont certaines constituent des nervures de rigidification des colonnettes 58, tandis qu'un faible jeu (figure 28) existe entre le couvercle 6 et la face supérieure du support. Ce jeu est comblé par la résine. Dans tous les cas le support 8 est positionné mécaniquement au moins par les colonnettes 58 et /ou le bord vertical du boîtier et est en appui mécanique au moins sur les saillies 57. Les éléments des moyens 9 ont donc uniquement une fonction de liaison électrique entre le shunt 7 et le support 8 en sorte qu'ils sont ménagés. Le support 8 en variante est également en appui mécanique sur un rebord du boîtier 5 qui sert également à positionner mécaniquement par coopération de formes le support 8.

On appréciera que la résine de protection et de fixation permet également de filtrer les vibrations

Bien entendu la présente invention n'est pas limitée aux exemples de réalisation décrits.

En particulier le goujon 15 est en variante fixé par soudage sur la patte 36 de la cosse 3.

L'extrémité supérieure filetée du goujon 15 est en variante remplacée par une borne tronconique pour fixation du câble de batterie concerné à l'aide d'une cosse à pattes de serrage et manchon du type de la cosse 2.

Ainsi qu'il ressort de ce qui précède les moyens d'assemblage 14 sont en variante distincts des moyens de fixation du câble à la cosse supérieure.

Par exemple le goujon 15 est en variante fixé sur la cosse supérieure 3 par exemple à l'aide d'un écrou ou par soudage, tandis que le câble est fixé à son extrémité par exemple directement par soudage ou sur une borne supplémentaire de la cosse supérieure 3.

La surépaisseur 25 de la cosse 2 est en variante élargie pour la fixation d'autre fils électriques du circuit électrique du véhicule.

Comme visible à la figure 30 le boîtier 5 est en variante doté d'un rebord horizontal 300 dirigé vers l'intérieur du boîtier, de crans 100, tel que des crans de forme pointue, et de colonnettes de centrage 200 du support 8 pénétrant chacune dans un trou du support 8.

Le montage du support 8 dans le boîtier 5 est réalisé par encliquetage à la faveur des crans 100. Le support 8 prend en final appui sur le rebord 300 avec apparition d'un jeu entre le rebord 300 et la face interne des crans. Ce jeu est comblé par la résine.

Le couvercle 6 ne participe plus alors à l'immobilisation du support 8 emprisonné entre les crans 100 et le rebord 300.

Dans tous les cas le carter comporte des moyens d'appui et de positionnement mécanique du support 8.

Dans un mode de réalisation le support est porté à fixation et bloqué par le carter 5,6.

Les éléments des moyens de liaison électrique 9 présentent deux extrémités de forme identique à celle des têtes des éléments de la figure 28 pour montage du type press-fit sur le shunt 7 et sur le support 8 ; le shunt présentant alors des ouvertures à cet effet.

Les moyens 9 comportent en variante des fils gainés dont les extrémités sont soudées sur le shunt 7 et sur une trace électrique du support 8. Les fils traversent le support 8.

En variante la nervure 56' est décalée (figure 27) pour coopérer avec la face externe du bord latéral du bras 38 comme visible à la figure 28.

Bien entendu la forme du support de soutien 29 peut être modifiée. Par exemple le support 29 à surface 129 peut présenter un bord arrondi.

En variante on peut décaler circonférentiellement la protubérance 27, qui en variante n'est donc pas diamétralement opposée à la fente du manchon 21. Cela est fonction des applications et plus particulièrement de l'environnement au niveau de la batterie.

La partie de serrage 21, 22 de la cosse 2 peut avoir une autre forme, qui dépend de celle de la borne de la batterie sur laquelle se monte la partie de serrage 21, 22.

Bien entendu on peut augmenter l'épaisseur d'au moins l'une des pattes d'assemblage 26, 36 et/ou de l'un au moins des bras 28, 38 en sorte que le bras concerné 28, 38 se raccorde dans un autre mode de réalisation directement à cette pattes 26, 36 ; la ou les portions inclinées 128, 138 étant supprimées.

Ainsi on peut augmenter l'épaisseur de la patte 26 pour supprimer la portion inclinée 128. On peut dans une variante augmenter localement l'épaisseur du bras 38 jusqu'à son épaulement 221 pour supprimer la portion inclinée 138.

Ainsi en variante l'un au moins de bras 28, 38 se raccorde à sa patte d'assemblage 26, 36 par une portion inclinée 128, 138 en sorte que ledit bras 28, 38 est décalé par rapport à sa patte d'assemblage 26, 36.

Bien entendu on peut modifier localement la section d'au moins l'un des bras 28, 38 au niveau de son extrémité libre. Par exemple la section de l'extrémité libre d'un bras 28, 38 est en variante de section circulaire dotée de deux méplats, l'un pour la fixation du shunt, l'autre pour appui de l'électrode de soudage.

Bien entendu lorsque le shunt est fixé par collage sur le bras, un seul méplat suffit, à savoir celui pour l'appui du shunt 7.

Les bras présentent dans tous les cas à leur périphérie externe une partie plane épaulée pour la fixation du shunt s'étendant perpendiculairement par rapport à la protubérance 27.

En variante seul l'un des bras 28, 38 présente un épaulement à sa périphérie interne un épaulement 121,131 pour coopérer en butée avec le bord 58 du fond 59 du boîtier 5.

De même en variante les moyens de blocage en rotation par coopération de formes interviennent entre l'entretoise 4 et uniquement l'une des pattes d'assemblage 26, 36.

De manière précitée on peut inverser les structures, le couvercle 6 (Figure 31) étant plus profond que le boîtier 5. Par exemple la hauteur du bord vertical 259' du boîtier 5 à rainure 160' est égale à la hauteur du bord vertical 359 à rainure 160 de la figure 28, tandis que la hauteur du bord vertical 359' à rebord 60' du couvercle 6 est égale à celle du bord 259 à rebord 60 de cette figure 28.

Le fond du couvercle peut présenter des saillies 601, dont l'une est visible à la figure 31, pour coopérer de manière directe ou indirecte, via la résine, avec la face supérieure du support 8. Dans ce mode de réalisation le rebord 60' est en contact avec le fond de la rainure 160'.

Dans tous les cas on prévoit un jeu de montage car le couvercle à rainure 160 ou à rebord 60' et saillies 601 ne peut coopérer à la fois avec le bord 259, 259' du boîtier à rebord 60 ou à rainure 160' et avec la face supérieure du support 8.

Le jeu est faible et est comblé par la résine pour bien immobiliser le support 8

La face interne du bord vertical du couvercle 6 peut coopérer à coopération de formes avec le bord du support pour positionner mécaniquement le support 8. Dans ce cas le bord vertical 359' du couvercle 6 est entaillé pour formation de l'ouverture latérale 55 et on remplit le carter de résine à la faveur de l'ouverture latérale 55.

Le carter est dans un mode de réalisation de forme parallélépipédique.

## Revendications

1. Cosse de batterie (1) équipée d'un shunt (7) de mesure du courant de la batterie et d'un support (8), tel qu'un circuit imprimé, d'au moins un composant électronique, comprenant une première partie (2) configurée pour être fixée à une borne de la batterie **caractérisée en ce qu'**elle comporte une deuxième partie (3) configurée pour être fixée au câble de la batterie associé à ladite borne de la batterie, **en ce que** les deux parties (2,3) sont distinctes l'une de l'autre et dotées de portions saillantes (28, 38) pour porter le shunt (7) et un carter (5, 6) de logement du shunt (7) et du support (8) et **en ce que** des moyens d'isolation électrique (4, 17) interviennent entre les deux parties (2, 3) de la cosse (1).

2. Cosse selon la revendication 1, **caractérisée en ce que** le carter (5, 6) est doté, d'une part, de moyens pour positionner mécaniquement le support (8) et d'autre part, de moyens d'appui mécanique pour le support (8).

3. Cosse selon la revendication 1 ou 2, **caractérisée en ce que** le carter (5, 6) présente une ouverture latérale (55) dans laquelle pénètre les portions saillantes (28, 38) des deux parties (2, 3) de la cosse et **en ce que** les portions saillantes (28, 38) des deux parties sont implantées globalement l'une au dessus de l'autre.

4. Cosse selon la revendication 3, **caractérisée en ce que** le carter (5, 6) est rempli de résine de fixation du carter (5, 6) aux portions saillantes (28, 38) des deux parties (2, 3) de la cosse (1) et de protection des composants montés dans le carter.

5. Cosse selon la revendication 3 ou 4, **caractérisée en ce que** la première partie (2) de la cosse (1) présente une protubérance (27) dotée d'une première patte d'assemblage (26) de la deuxième partie (3) à la première partie (2), **en ce que** la deuxième partie (3) présente une deuxième patte d'assemblage (36) pour son assemblage à la première patte d'assemblage (26), **en ce que** la portion saillante (28) de la première partie (2) est porté en saillie par la première patte d'assemblage (26) et **en ce que** la portion saillante (38) de la seconde partie (3) est porté en saillie par la deuxième patte d'assemblage (36) 13.

6. Cosse selon la revendication 5, **caractérisée en ce que** la première patte d'assemblage (26) et la deuxième patte d'assemblage (36) sont trouées pour le passage de moyens d'assemblage (14) entre les deux pattes (26, 36) et **en ce que** les moyens des moyens d'isolation électrique (4, 17) appartiennent aux moyens d'assemblage (14).

7. Cosse selon la revendication 6, **caractérisée en ce que** les moyens d'isolation électrique (4, 17) comportent une entretoise électriquement isolante (4), **en ce que** la première patte d'assemblage (26) porte à fixation des moyens d'assemblage (14) traversant le trou (126) de la première patte d'assemblage avec interposition de l'entretoise (4) électriquement isolante pour isoler les moyens d'assemblage (14) par rapport à la première patte d'assemblage (26).

8. Cosse selon la revendication 7, **caractérisée en ce que** les moyens d'assemblage (14) comportent un goujon (15) avec deux parties filetées traversant respectivement le trou (126) de la première patte d'assemblage (26) et le trou (136) de la deuxième patte d'assemblage (36), **en ce que** le goujon (15) comporte une partie de serrage (18) entre ses deux parties filetées, **en ce que** la partie de serrage (18) est, d'une part, intercalée entre les deux pattes d'assemblage (26, 36) et est d'autre part montée dans une cavité (43) que présente l'entretoise (4), **en ce que** la hauteur de la partie de serrage (18) est plus haute que celle de l'entretoise (4) et **en ce que** le fond de la cavité (43) est prolongé par un manchon (42) engagé dans le trou (126) de la première patte d'assemblage et traversé par la partie filetée concernée du goujon (15).

9. Cosse selon la revendication 8, **caractérisée en ce que** des moyens de blocage en rotation par coopération de formes interviennent entre l'entretoise (4) et au moins l'une des pattes d'assemblage (26,36).

10. Cosse selon l'une quelconque des revendications 6 à 9, **caractérisée en ce que** la première partie (2) de la cosse (1) présente un manchon (21) et **en ce que** l'entretoise (4) présente un secteur annulaire avec une jupe de protection en contact avec le manchon (21) et une deuxième jupe de protection masquant en partie la portion saillante (38) de la deuxième partie (3) de la cosse (1).

11. Cosse selon l'une quelconque des revendications 5 à 10, **caractérisé en ce que** les portions saillantes (28, 38) consistent en des bras (28, 38), **en ce que** le bras (28) de la première partie (2) est porté en saillie par la première patte d'assemblage (26), **en ce que** le bras (38) de la seconde partie (3) est porté en saillie par la deuxième patte d'assemblage (36) et s'étend parallèlement au bras (28) de la première patte d'assemblage (26) et **en ce que** les bras (28,38) présentent chacun à leur périphérie externe une partie plane épaulée pour la fixation du shunt (7) s'étendant perpendiculairement par rapport à la protubérance (27).

12. Cosse selon la revendication 11, **caractérisé en ce que** l'un au moins des bras (28, 38) se raccorde à sa patte d'assemblage (26, 36) par une portion inclinée (128, 138) en sorte que ledit bras (28, 38)) est décalé par rapport à sa patte d'assemblage (26, 36).

13. Cosse selon l'une quelconque des revendications 5 à 12 prises en combinaison avec la revendication 11, **caractérisée en ce que** la protubérance (27) comporte un support de soutien (29) présentant à sa périphérie externe une surface (129) parallèle au bras (28) de la première partie (2).

14. Cosse selon la revendication 13, **caractérisée en ce que** la surface externe (129) du support (29) et la périphérie interne du bras (28) tournée vers la surface externe du support de soutien (29) définissent une rainure (30) pour le montage par enfilage du carter (5,6) à la faveur de l'ouverture latérale (55) du carter (5,6).

15. Cosse selon la revendication 14, **caractérisée en ce que** la première partie (2) de la cosse (1) présente un manchon (21) de serrage, **en ce que** la protubérance (27) s'étend perpendiculairement au manchon (21) et **en ce que** le support de soutien (29) et la première patte d'assemblage (26) s'étendent de part et d'autre du manchon (21).

16. Cosse selon la revendication 14 ou 15, **caractérisée en ce que** le carter (5,6) comporte un boîtier (5) fermé par un couvercle (6), **en ce que** le boîtier (5) comporte un fond (59) délimitant l'ouverture latérale (55) et **en ce que** la largeur de la rainure (30) est globalement égale à l'épaisseur du fond (59) du boîtier (5).

17. Cosse selon la revendication 16, **caractérisée en ce que** le fond (59) du boîtier (5) comporte deux nervures (56,56') formant deux rails de guidage pour l'ensemble bras (28,38) - shunt (7).

18. Cosse selon l'une quelconque des revendications 3 à 17, **caractérisée en ce que** l'un ou moins des bras (28,38) présente à sa périphérie interne un épaulement (121,131) pour coopérer en butée avec le bord (58) du fond (59) du boîtier (5).

19. Cosse selon l'une quelconque des revendications précédentes, **caractérisée en ce que** le carter (5,6) comporte un boîtier (5) doté de saillies (57) d'appui du support (8).

20. Cosse selon l'une quelconque des revendications précédentes, **caractérisée en ce que** des moyens de liaison électrique du press-fit interviennent entre le shunt (7) et le support (8).

## Patentansprüche

1. Batteriekabelschuh (1), der mit einem Shunt (7) zum Messen des Stroms der Batterie und einem Träger (8), wie einer gedruckten Schaltung, mindestens eines Elektronikbauteils, umfassend einen ersten Teil (2), der dazu vorgesehen ist, an einer Klemme der Batterie befestigt zu werden, ausgestattet ist, **dadurch gekennzeichnet, dass** er einen zweiten Teil (3) umfasst, der dazu vorgesehen ist, am der Klemme der Batterie zugeordneten Kabel der Batterie befestigt zu werden, dass die beiden Teile (2, 3) voneinander getrennt und mit vorspringenden Abschnitten (28, 38) versehen sind, um den Shunt (7) und ein Gehäuse (5, 6) zur Lagerung des Shunts (7) und des Trägers (8) zu tragen, und dass elektrische Isoliermittel (4, 17) zwischen den beiden Teilen (2, 3) des Kabelschuhs (1) angeordnet sind.

2. Kabelschuh nach Anspruch 1, **dadurch gekennzeichnet, dass** das Gehäuse (5, 6) einerseits mit Mitteln zur mechanischen Positionierung des Trägers (8) und andererseits mit mechanischen Stützmitteln für den Träger (8) versehen ist.

3. Kabelschuh nach Anspruch 1 oder 2, **dadurch gekennzeichnet, dass** das Gehäuse (5, 6) eine seitliche Öffnung (55) aufweist, in die die vorspringenden Abschnitte (28, 38) der beiden Teile (2, 3) des Kabelschuhs eindringen, und dass die vorspringenden Abschnitte (28, 38) der beiden Teile global übereinander angeordnet sind.

4. Kabelschuh nach Anspruch 3, **dadurch gekennzeichnet, dass** das Gehäuse (5, 6) mit Harz zur Befestigung des Gehäuses (5, 6) an den vorspringenden Abschnitten (28, 38) der beiden Teile (2, 3) des Kabelschuhs (1) und zum Schutz der in dem Gehäuse montierten Bauteile gefüllt ist.

5. Kabelschuh nach Anspruch 3 oder 4, **dadurch gekennzeichnet, dass** der erste Teil (2) des Kabelschuhs (1) eine Ausstülpung (27) aufweist, die mit einer ersten Verbindungsklaue (26) des zweiten Teils (3) am ersten Teil (2) versehen ist, dass der zweite Teil (3) eine zweite Verbindungsklaue (36) zu seiner Verbindung mit der ersten Verbindungsklaue (26) aufweist, dass der vorspringende Abschnitt (28) des ersten Teils (2) vorspringend von der ersten Verbindungsklaue (26) getragen wird, und dass der vorspringende Abschnitt (38) des zweiten Teils (3) vorspringend vom zweiten Verbindungsteil (36) getragen wird.

6. Kabelschuh nach Anspruch 5, **dadurch gekennzeichnet, dass** die erste Verbindungsklaue (26) und die zweite Verbindungsklaue (36) mit Löchern für den Durchgang von Verbindungsmitteln (14) zwischen den beiden Klauen (26, 36) versehen sind, und dass die elektrischen Isoliermittel (4, 17) den Verbindungsmitteln (14) angehören.

7. Kabelschuh nach Anspruch 6, **dadurch gekennzeichnet, dass** die elektrischen Isoliermittel (4, 17) eine elektrisch isolierende Querstrebe (4) umfassen, dass die erste Verbindungsklaue (26) an ihr befestigte Verbindungsmittel (14) trägt, die durch das Loch (126) der ersten Verbindungsklaue hindurchgehen, wobei die elektrisch isolierende Querstrebe (4) dazwischen angeordnet ist, um die Verbindungsmittel (14) in Bezug zu der ersten Verbindungsklaue (26) zu isolieren.

8. Kabelschuh nach Anspruch 7, **dadurch gekennzeichnet, dass** die Verbindungsmittel (14) einen Stift (15) mit zwei Teilen, die durch das Loch (126) der ersten Verbindungsklaue (26) bzw. das Loch (136) der zweiten Verbindungsklaue (36) hindurchgehen, umfassen, dass der Stift (15) einen Spannteil (18) zwischen seinen beiden Gewindeteilen umfasst, dass der Spannteil (18) einerseits zwischen den beiden Verbindungsklauen (26, 36) angeordnet und andererseits in einem Hohlraum (43), den die Querstrebe (4) aufweist, montiert ist, dass die Höhe des Spannteils (18) größer als jene der Querstrebe (4) ist, und dass der Boden des Hohlraums (43) durch eine Hülse (42) verlängert ist, die in das Loch (126) des ersten Verbindungsteils eingreift und von dem betreffenden Gewindeteil des Stiftes (15) durchquert wird.

9. Kabelschuh nach Anspruch 8, **dadurch gekennzeichnet, dass** Drehfeststellungsmittel durch Formzusammenwirken zwischen der Querstrebe (4) und mindestens einer der Verbindungsklauen (26, 36) angeordnet sind.

10. Kabelschuh nach einem der Ansprüche 6 bis 9, **dadurch gekennzeichnet, dass** der erste Teil (2) des Kabelschuhs (1) eine Hülse (21) aufweist, und dass die Querstrebe (4) einen Ringsektor mit einer Schutzschürze in Kontakt mit der Hülse (21) und einer zweiten Schutzschürze, die teilweise den vorspringenden Abschnitt (38) des zweiten Teils (3) des Kabelschuhs (1) verdeckt, aufweist.

11. Kabelschuh nach einem der Ansprüche 5 bis 10, **dadurch gekennzeichnet, dass** die vorspringenden Abschnitte (28, 38) in Armen (28, 38) bestehen, dass der Arm (28) des ersten Teils (2) von der ersten Verbindungsklaue (26) vorspringend getragen wird, dass der Arm (38) des zweiten Teils (3) von der zweiten Verbindungsklaue (36) vorspringend getragen wird und sich parallel zum Arm (28) der ersten Verbindungsklaue (26) erstreckt, und dass die Arme (28, 38) jeweils an ihrer äußeren Peripherie einen flachen abgesetzten Teil für die Befestigung des Shunts (7) aufweisen, der sich senkrecht auf die Ausstülpung (27) erstreckt.

12. Kabelschuh nach Anspruch 11, **dadurch gekennzeichnet, dass** sich der mindestens eine der Arme (28, 38) an seine Verbindungsklaue (26, 36) durch einen geneigten Abschnitt (128, 138) anschließt, so dass der Arm (28, 38) in Bezug zu seiner Verbindungsklaue (26, 36) versetzt ist.

13. Kabelschuh nach einem der Ansprüche 5 bis 12 in Kombination mit Anspruch 11, **dadurch gekennzeichnet, dass** die Ausstülpung (27) einen Stützträger (29) umfasst, der an seiner äußeren Peripherie eine Fläche (129) parallel zum Arm (28) des ersten Teils (2) aufweist.

14. Kabelschuh nach Anspruch 13, **dadurch gekennzeichnet, dass** die Außenfläche (129) des Trägers (29) und die innere Peripherie des Arms (28), die zur Außenfläche des Stützträgers (29) gewandt ist, eine Nut (30) für die Montage des Gehäuses (5, 6) durch die seitliche Öffnung (55) des Gehäuses (5, 6) durch Einschieben umfasst.

15. Kabelschuh nach Anspruch 14, **dadurch gekennzeichnet, dass** der erste Teil (2) des Kabelschuhs (1) eine Spannhülse (21) aufweist, dass sich die Ausstülpung (27) senkrecht auf die Hülse (21) erstreckt, und dass sich der Stützträger (29) und die erste Verbindungsklaue (26) beiderseits der Hülse (21) erstrecken.

16. Kabelschuh nach Anspruch 14 oder 15, **dadurch gekennzeichnet, dass** das Gehäuse (5, 6) ein durch einen Deckel (6) geschlossenes Behältnis (5) umfasst, dass das Behältnis (5) einen Boden (59) umfasst, der eine seitliche Öffnung (55) begrenzt, und dass die Breite der Nut (30) global gleich der Dicke des Bodens (59) des Behältnisses (5) ist.

17. Kabelschuh nach Anspruch 16, **dadurch gekennzeichnet, dass** der Boden (59) des Behältnisses (5) zwei Rippen (56, 56') umfasst, die zwei Führungsschienen für die Einheit Arm (28, 38) - Shunt (7) bilden.

18. Kabelschuh nach einem der Ansprüche 3 bis 17, **dadurch gekennzeichnet, dass** mindestens einer der Arme (28, 38) an seiner inneren Peripherie einen Absatz (121, 131) aufweist, um am Anschlag mit dem Rand (58) des Bodens (59) des Gehäuses (5) zusammenzuwirken.

19. Kabelschuh nach einem der vorhergehenden Ansprüche, **dadurch gekennzeichnet, dass** das Gehäuse (5, 6) ein Behältnis (5) umfasst, das mit Stützvorsprüngen (57) für den Träger (8) versehen ist.

20. Kabelschuh nach einem der vorhergehenden Ansprüche, **dadurch gekennzeichnet, dass** elektrische Verbindungsmittel des Einpresselements zwischen dem Shunt (7) und dem Träger (8) angeordnet sind.

## Claims

1. Battery terminal lug (1) equipped with a shunt (7) for measuring the current of the battery and a support (8), such as a printed circuit, for at least one electronic component, comprising a first part (2) configured to be fixed to a terminal of the battery, **characterized in that** it comprises a second part (3) configured to be fixed to the cable of the battery associated with said battery terminal, **in that** the two parts (2, 3) are distinct from one another and provided with protruding portions (28, 38) to bear the shunt (7) and a case (5, 6) for housing the shunt (7) and the support (8) and **in that** electrical insulation means (4, 17) are located between the two parts (2, 3) of the terminal lug (1).

2. Terminal lug according to Claim 1, **characterized in that** the case (5, 6) is provided, on the one hand, with means for mechanically positioning the support (8) and, on the other hand, mechanical bearing means for the support (8).

3. Terminal lug according to Claim 1 or 2, **characterized in that** the case (5, 6) has a lateral opening (55) into which the protruding portions (28, 38) of the two parts (2, 3) of the terminal lug penetrate, and **in that** the protruding portions (28, 38) of the two parts are located generally one on top of the other.

4. Terminal lug according to Claim 3, **characterized in that** the case (5, 6) is filled with resin for fixing the case (5, 6) to the protruding portions (28, 38) of the two parts (2, 3) of the terminal lug (1) and for protecting the components mounted in the case.

5. Terminal lug according to Claim 3 or 4, **characterized in that** the first part (2) of the terminal lug (1) has a protuberance (27) provided with a first tab (26) for joining the second part (3) to the first part (2), **in that** the second part (3) has a second joining tab (36) for it to be joined to the first joining tab (26), **in that** the protruding portion (28) of the first part (2) is protrudingly borne by the first joining tab (26) and **in that** the protruding portion (38) of the second part (3) is protrudingly borne by the second joining tab (36).

6. Terminal lug according to Claim 5, **characterized in that** the first joining tab (26) and the second joining tab (36) are holed for the passage of joining means (14) between the two tabs (26, 36) and **in that** the electrical insulation means (4, 17) belong to the joining means (14).

7. Terminal lug according to Claim 6, **characterized in that** the electrical insulation means (4, 17) comprise an electrical insulating spacer (4), **in that** the first joining tab (26) is for fixing joining means (14) passing through the hole (126) of the first joining tab with the interposition of the electrically insulating spacer (4) to insulate the joining means (14) relative to the first joining tab (26).

8. Terminal lug according to Claim 7, **characterized in that** the joining means (14) comprise a stud (15) with two threaded parts passing respectively through the hole (126) of the first joining tab (26) and the hole (136) of the second joining tab (36), **in that** the stud (15) comprises a tightening part (18) between its two threaded parts, **in that** the tightening part (18) is, on the one hand, inserted between the two joining tabs (26, 36) and is, on the other hand, mounted in a cavity (43) of the spacer (4), **in that** the height of the tightening part (18) is higher than that of the spacer (4) and **in that** the bottom of the cavity (43) is prolonged by a sleeve (42) engaged in the hole (126) of the first joining tab and passed through by the relevant threaded part of the stud (15)

9. Terminal lug according to Claim 8, **characterized in that** rotation blocking means based on cooperation of forms are located between the spacer (4) and at least one of the joining tabs (26, 36).

10. Terminal lug according to any one of Claims 6 to 9, **characterized in that** the first part (2) of the terminal lug (1) has a sleeve (21) and **in that** the spacer (4) has an annular segment with a protection skirt in contact with the sleeve (21) and a second protection skirt partly concealing the protruding portion (38) of the second part (3) of the terminal lug (1).

11. Terminal lug according to any one of Claims 5 to 10, **characterized in that** the protruding portions (28, 38) consist of arms (28, 38), **in that** the arm (28) of the first part (2) is protrudingly borne by the first joining tab (26), **in that** the arm (38) of the second part (3) is protrudingly borne by the second joining tab (36) and extends parallel to the arm (28) of the first joining tab (26) and **in that** the arms (28, 38) each have, on their outer periphery, a shouldered planar part for fixing the shunt (7) extending at right angles relative to the protuberance (27).

12. Terminal lug according to Claim 11, **characterized in that** at least one of the arms (28, 38) is connected to its joining tab (26, 36) by an inclined portion (128, 138) such that said arm (28, 38) is offset relative to its joining tab (26, 36).

13. Terminal lug according to any one of Claims 5 to 12 taken in combination with Claim 11, **characterized in that** the protuberance (27) comprises a cleat support (29) having, on its outer periphery, a surface (129) parallel to the arm (28) of the first part (2).

14. Terminal lug according to Claim 13, **characterized in that** the outer surface (129) of the support (29) and the inner periphery of the arm (28) turned towards the outer surface of the cleat support (29) define a groove (30) threadingly mounting the case (5, 6) with the aid of the lateral opening (55) of the case (5, 6).

15. Terminal lug according to Claim 14, **characterized in that** the first part (2) of the terminal lug (1) has a tightening sleeve (21), **in that** the protuberance (27) extends at right angles to the sleeve (21) and **in that** the cleat support (29) and the first joining tab (26) extend on either side of the sleeve (21).

16. Terminal lug according to Claim 14 or 15, **characterized in that** the case (5, 6) comprises a casing (5) closed by a cover (6), **in that** the casing (5) comprises a bottom (59) delimiting the lateral opening (55) and **in that** the width of the groove (30) is overall equal to the thickness of the bottom (59) of the casing (5).

17. Terminal lug according to Claim 16, **characterized in that** the bottom (59) of the casing (5) comprises two ribs (56, 56') forming two guiding rails for the arms (28, 38) - shunt (7) assembly.

18. Terminal lug according to any one of Claims 3 to 17, **characterized in that** at least one of the arms (28, 38) has, on its inner periphery, a shoulder (121, 131) for cooperating by abutment with the edge (58) of the bottom (59) of the casing (5).

19. Terminal lug according to any one of the preceding claims, **characterized in that** the case (5, 6) comprises a casing (5) provided with protrusions (57) for bearing the support (8).

20. Terminal lug according to any one of the preceding claims, **characterized in that** press-fit electrical link means are provided between the shunt (7) and the support (8).
